# FASCICULE DE BREVET EUROPEEN

(11) **EP 3 782 193 B1**
(45) Date de publication et mention de la délivrance du brevet: **04.05.2022**
(21) Numéro de dépôt: 19772777.9
(22) Date de dépôt: 17.04.2019
(51) Int. Cl.: H01L 27/15, H01L 27/144, H01L 33/00, H01L 33/12, H01L 21/20, H01L 25/16, H01L 33/20

(54) **PROCÉDÉ DE FABRICATION D'UN DISPOSITIF OPTOÉLECTRONIQUE À MATRICE DE DIODES**
HERSTELLUNGSVERFAHREN EINER OPTOELEKTRONISCHEN VORRICHTUNG MIT DIODENMATRIX
METHOD OF MANUFACTURING AN OPTOELECTRONIC DEVICE HAVING A MATRIX OF DIODES

(30) Priorité: 20.04.2018 FR 1853495
(43) Date de publication de la demande: 24.02.2021
(73) Titulaire: COMMISSARIAT À L'ÉNERGIE ATOMIQUE ET AUX ÉNERGIES ALTERNATIVES, 75015 Paris (FR)
(72) Inventeur: CHARLES, Matthew, 38054 GRENOBLE Cedex 9 (FR)
(74) Mandataire: INNOV-GROUP
(86) Numéro de dépôt international: PCT/FR2019/050913
(87) Numéro de publication internationale: WO 2019/202258

(56) Documents cités:
- EP-A2- 1 667 228
- US-A1- 2002 079 498
- US-A1- 2013 221 368
- US-A1- 2014 246 647
- US-A1- 2015 137 072
- US-A1- 2017 352 532
- US-B1- 6 342 404

## Description

### DOMAINE TECHNIQUE

Le domaine de l'invention est celui des dispositifs optoélectroniques à matrice de diodes électroluminescentes ou de photodiodes. L'invention s'applique notamment au domaine des dispositifs d'éclairage, des écrans d'affichage et des projecteurs d'images, ainsi qu'au domaine des photodétecteurs et des capteurs.

### ÉTAT DE LA TECHNIQUE ANTÉRIEURE

Il existe des dispositifs optoélectroniques à matrice de diodes électroluminescentes adaptées à former des dispositifs d'éclairage, des écrans d'affichage ou des projecteurs d'images.

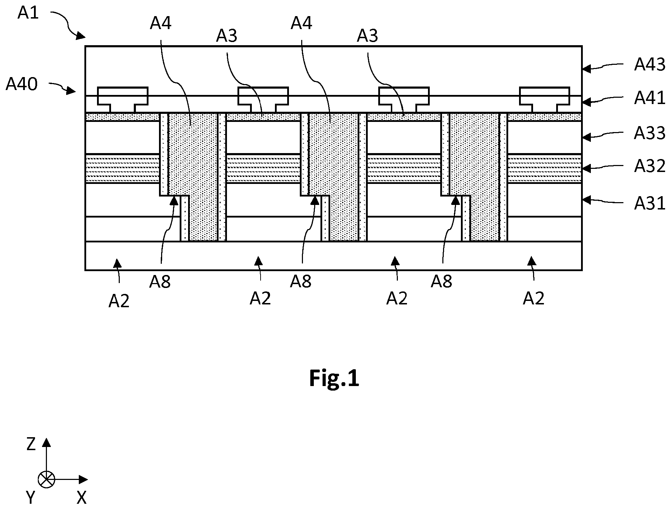

Ainsi, le document EP 2 960 940 A1 illustre un exemple de dispositif optoélectronique à matrice de diodes électroluminescentes. Comme l'illustre de manière schématique la figure 1, ce dispositif optoélectronique A1 comporte une pluralité de diodes électroluminescentes A2 comportant chacune un empilement semiconducteur formé d'une portion A31 dopée n et d'une portion A33 dopée p séparées l'une de l'autre par une zone active A32 d'où est majoritairement généré le rayonnement lumineux de la diode électroluminescente A2.

Les diodes électroluminescentes A2 présentent une structure dite mesa, c'est-à-dire qu'elles sont obtenues à partir d'un empilement de couches semiconductrices bidimensionnelles destinées à former les différentes portions dopées A31, A33 et les zones actives A32, une gravure localisée étant effectuée de manière à individualiser les diodes électroluminescentes A2 les unes des autres. Dans cet exemple, chaque diode A2 comporte une forme en L dont les flancs sont revêtus d'une couche isolante de passivation, hormis au niveau d'un décrochement A8 que forme la portion dopée A31. Des électrodes A3 reposent sur les portions dopées A33 et des électrodes A4 s'étendent entre les diodes A2 et viennent au contact des décrochements A8 formés par les portions dopées A31. Chaque pixel d'affichage comporte alors un empilement semiconducteur formé des portions dopées A31, A33 et de la zone active A32, ainsi que les électrodes A3 et A4. Une puce de commande A40 est hybridée à la matrice de diodes électroluminescentes A2, et comporte ici une couche de raccord électrique A41 et une couche de circuit intégré A43.

Un procédé de fabrication de ce dispositif optoélectronique présente cependant l'inconvénient de nécessiter une étape de gravure localisée des couches semiconductrices bidimensionnelles dopées et de la couche active, dans le but de pixelliser les diodes. Or cette étape de gravure peut d'entraîner la formation de défauts, surtout sur les flancs gravés, susceptibles de dégrader la performance des diodes, dans la mesure où une passivation incorrecte ou insuffisante des flancs peut générer des fuites.

Par ailleurs, la différence de paramètres de maille entre le substrat de croissance et les couches semiconductrices épitaxiées peut engendrer la formation de défauts cristallins, notamment des dislocations traversantes qui s'étendent suivant la direction de croissance, venant ainsi dégrader la qualité cristalline de l'empilement semiconducteur, et dégrader en conséquence les performances des diodes.

De plus, lors du refroidissement après l'étape de croissance épitaxiale, la différence de coefficients de dilatation thermique entre le substrat de croissance et l'empilement semiconducteur, par exemple entre le silicium du substrat et le matériau semiconducteur à base de nitrure, peut générer une forte contrainte mécanique en tension dans l'empilement semiconducteur, susceptible d'entraîner des fissures dans l'empilement semiconducteur, ou de courber fortement la plaque. A ce titre, des techniques d'ingénierie de la contrainte mécanique peuvent prévoir d'introduire volontairement une contrainte initiale compressive du matériau semiconducteur au cours de la croissance, par exemple en insérant des inter-couches d'AlN ou des gradients d'AlGaN.

Les documents de l'art antérieur US 2002/0079498 A1, EP 1 667 228 A2, US 2015/0137072 A1, US 6 342 404 B1 et US 2014/0246647 A1 illustrent divers autres procédés de fabrication de dispositifs optoélectroniques à matrice de diodes.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique à matrice de diodes permettant de réduire les risques de dégradation de la qualité cristalline du composé semiconducteur à base duquel sont réalisées les diodes.

Pour cela, l'objet de l'invention est un procédé de fabrication d'un dispositif optoélectronique à matrice de diodes, chaque diode comportant : un empilement semiconducteur formé d'une première portion dopée et d'une deuxième portion dopée entre lesquelles est située une zone active. Chaque empilement semiconducteur présente un coefficient de dilatation thermique αₑₛ. Le procédé comporte les étapes suivantes :
i) fournir un substrat de croissance présentant un coefficient de dilatation thermique α_{sc} inférieur à αₑₛ, et ayant une surface de nucléation ;
ii) déposer, sur la surface de nucléation, une couche diélectrique réalisée en un matériau électriquement isolant présentant un coefficient de dilatation thermique α_{mc} inférieur à αₑₛ ;
iii) former, dans la couche diélectrique, une pluralité d'ouvertures traversantes débouchant sur la surface de nucléation ;
iv) réaliser par croissance épitaxiale, dans les ouvertures traversantes et à partir de la surface de nucléation, lesdits empilements semiconducteurs, de sorte qu'au moins les premières portions dopées et les zones actives sont situées dans les ouvertures traversantes.

De plus, le substrat de croissance comporte un substrat support revêtu d'une couche de nucléation qui définit la surface de nucléation. Lors de l'étape iii), on réalise en outre :
- une gravure de la couche de nucléation située dans les ouvertures traversantes, de manière à rendre libre une surface supérieure du substrat support, et à exposer une face latérale de la couche de nucléation formant une face latérale de nucléation ; puis
- une formation d'une région diélectrique s'étendant dans ou sur le substrat support à partir de la surface supérieure du substrat support, de sorte que, lors de l'étape iv), les premières portions dopées sont formées notamment à partir de la face latérale de nucléation.

Chaque ouverture traversante peut déboucher verticalement sur la surface de nucléation, laquelle forme alors une face latérale de nucléation qui affleure une bordure latérale de la couche diélectrique, cette bordure latérale délimitant transversalement l'ouverture traversante. En variante, chaque ouverture traversante peut déboucher verticalement et latéralement sur la surface de nucléation, laquelle comporte alors une partie en saillie dans l'ouverture traversante.

Certains aspects préférés mais non limitatifs de ce procédé de fabrication sont les suivants.

Chaque ouverture traversante peut comporter une seule surface de nucléation, laquelle s'étend sur une partie du contour de l'ouverture traversante, et dont la face latérale de nucléation s'étend, dans un plan parallèle au plan du substrat support, de manière convexe ou continûment rectiligne.

Chaque ouverture traversante étant délimitée transversalement par au moins une bordure latérale de la couche diélectrique, la face latérale de nucléation peut affleurer la bordure latérale. Ainsi, la surface de nucléation n'est pas en saillie dans l'ouverture traversante.

Chaque ouverture traversante peut comporter une partie en saillie de la couche de nucléation, la partie en saillie s'étendant dans l'ouverture traversante sur le substrat support et étant non revêtue par la couche diélectrique. La partie en saillie peut être au contact du substrat support.

Une face supérieure (opposée au substrat support) de la partie en saillie peut participer à former la surface de nucléation.

Le procédé de fabrication peut comporter une étape de dépôt d'une couche mince diélectrique dans l'ouverture traversante de manière à recouvrir une face supérieure de la partie en saillie ainsi qu'une face supérieure (débouchant dans l'ouverture traversante) du substrat support formant ainsi la région diélectrique, tout en laissant libre la face latérale de nucléation.

La région diélectrique peut être formée par oxydation ou nitruration du substrat support à base de silicium, ou par dépôt d'une couche mince diélectrique.

Lors de l'étape de croissance épitaxiale, des espaces vides peuvent être formés entre les empilements semiconducteurs et la région diélectrique. Aussi, l'étape iv) de croissance épitaxiale peut être suivie d'une étape de retrait du substrat de croissance et d'une partie des empilements semiconducteurs contenant lesdits espaces vides, de manière à obtenir une face continue et sensiblement plane.

La couche diélectrique peut présenter une épaisseur e_{mc}, et chaque empilement semiconducteur peut présenter une épaisseur eₑₛ inférieure ou égale à e_{mc}.

Par ailleurs, l'épaisseur eₑₛ peut être inférieure à e_{mc}. L'étape iv) peut alors être suivie d'une étape de réalisation de deuxièmes électrodes reposant sur et en contact électrique avec les deuxièmes portions dopées, comportant les sous-étapes suivantes :
- déposer une couche conductrice d'une épaisseur au moins égale à la différence entre e_{mc} et eₑₛ, réalisée en au moins un matériau électriquement conducteur, de manière à recouvrir les empilements semiconducteurs et une face supérieure de la couche diélectrique ;
- planariser la couche conductrice, avec arrêt sur la face supérieure de la couche diélectrique, formant ainsi une pluralité de deuxièmes électrodes au contact avec les deuxièmes portions dopées et entourées chacune par la couche diélectrique, la face supérieure de la couche diélectrique et une face supérieure des deuxièmes électrodes formant alors une surface supérieure continue et sensiblement plane d'une structure optoélectronique.

Par ailleurs, l'épaisseur eₑₛ peut être inférieure à e_{mc}. Dans ce cas, l'étape iv) peut être suivie d'une étape de planarisation de la couche diélectrique avec arrêt de gravure sur une face supérieure des empilements semiconducteurs, une face supérieure de la couche diélectrique et la face supérieure des empilements semiconducteurs formant alors une surface supérieure continue et sensiblement plane d'une structure optoélectronique.

Le procédé peut comporter une étape d'hybridation de la structure optoélectronique, au niveau de sa surface supérieure, avec une puce de commande adaptée à appliquer une différence de potentiel aux diodes.

La structure optoélectronique et la puce de commande peuvent être hybridées par collage direct.

Chaque deuxième portion dopée peut comporter une première partie et une deuxième partie surdopée, la première partie étant située entre la deuxième partie surdopée et la zone active, et la deuxième partie surdopée présentant un niveau de dopage supérieur à celui de la première partie.

La deuxième portion dopée peut présenter un type de conductivité de type p.

Le substrat de croissance et la couche diélectrique peuvent être réalisés à base de silicium.

Les empilements semiconducteurs peuvent être réalisés à base d'un composé III-N.

A la suite de l'étape iii), chaque ouverture traversante peut s'étendre à partir de la surface de nucléation suivant un axe directeur incliné par rapport à un axe orthogonal à un plan principal du substrat de croissance.

Chaque zone active peut être distante de la surface de nucléation correspondante d'une hauteur minimale, la hauteur minimale et l'angle d'inclinaison de l'axe directeur étant préalablement déterminés de sorte que la zone active n'est pas située à l'aplomb de la surface de nucléation correspondante.

A la suite de l'étape iii), chaque ouverture traversante peut comporter une première cavité débouchant sur la surface de nucléation, et une deuxième cavité débouchant au niveau d'une face supérieure de la couche diélectrique et communiquant avec la première cavité, la couche diélectrique comportant une partie s'étendant sur le substrat de croissance et délimitant partiellement la deuxième cavité, la deuxième cavité étant décalée latéralement par rapport à la première cavité de sorte que, à la suite de l'étape iv), la zone active n'est pas située à l'aplomb de la surface de nucléation.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1, déjà décrite, est une vue schématique et partielle, en coupe transversale, d'un dispositif optoélectronique à matrice de diodes obtenu par un procédé de fabrication selon un exemple de l'art antérieur ;
les figures 2A à 2G sont des vues schématiques et partielles, en coupe transversale, de différentes étapes d'un procédé de fabrication d'un dispositif optoélectronique comportant la réalisation d'électrodes de polarisation avant hybridation, selon un exemple du contexte de la présente invention mais ne la définissant pas ;
les figures 3A à 3D sont vues schématiques et partielles, en coupe transversale, de différentes étapes d'un procédé de fabrication d'un dispositif optoélectronique ne comportant pas la réalisation d'électrodes de polarisation avant hybridation, selon un autre exemple du contexte de la présente invention mais ne la définissant pas ;
les figures 4A à 4C sont des vues schématiques et partielles, en coupe transversale, de différentes étapes d'un procédé de fabrication d'un dispositif optoélectronique dans lequel chaque ouverture traversante est inclinée, selon un exemple du contexte de la présente invention mais ne la définissant pas ;
les figures 5A à 5C sont des vues schématiques et partielles, en coupe transversale, de différentes étapes d'un procédé de fabrication d'un dispositif optoélectronique dans lequel chaque ouverture traversante est structurée de manière à présenter plusieurs cavités distinctes, selon un exemple du contexte de la présente invention mais ne la définissant pas ;
les figures 6A à 6D sont des vues schématiques et partielles, en coupe transversale, de différentes étapes d'un procédé de fabrication d'un dispositif optoélectronique selon un mode de réalisation dans lequel chaque ouverture traversante débouche sur une région diélectrique située dans le substrat de croissance, la surface de nucléation s'étendant sur la périphérie de l'ouverture traversante ;
les figures 7A et 7B sont des vues de dessus (fig.7A) et en coupe transversale (fig.7B), schématiques et partielles, d'un dispositif optoélectronique obtenu par un procédé de fabrication selon une variante du mode de réalisation illustré sur les fig.6A à 6D
les figures 8A et 8B sont des vues en coupe transversale (fig.8A) et de dessus (fig.8B), schématiques et partielles, d'un dispositif optoélectronique obtenu par un procédé de fabrication selon une variante de celui décrit en référence aux fig.6A à 6D ;
les figures 9A et 9B sont des vues en coupe transversale (fig.9A) et de dessus (fig.9B), schématiques et partielles, d'un dispositif optoélectronique obtenu selon un procédé de fabrication selon une variante du mode de réalisation illustré sur les fig.7A et 7B ;
les figures 10A à 10E sont des vues schématiques et partielles, en coupe transversale, de différentes étapes d'un procédé de fabrication d'un dispositif optoélectronique selon un autre mode de réalisation.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Sauf indication contraire, les termes « sensiblement », « environ », « de l'ordre de » signifient à 10% près. Par ailleurs, l'expression « comportant un » doit être comprise comme « comportant au moins un », sauf indication contraire.

L'invention porte sur un procédé de fabrication d'un dispositif optoélectronique 1 comportant une matrice de diodes 2. Ces dernières peuvent être des diodes électroluminescentes ou des photodiodes.

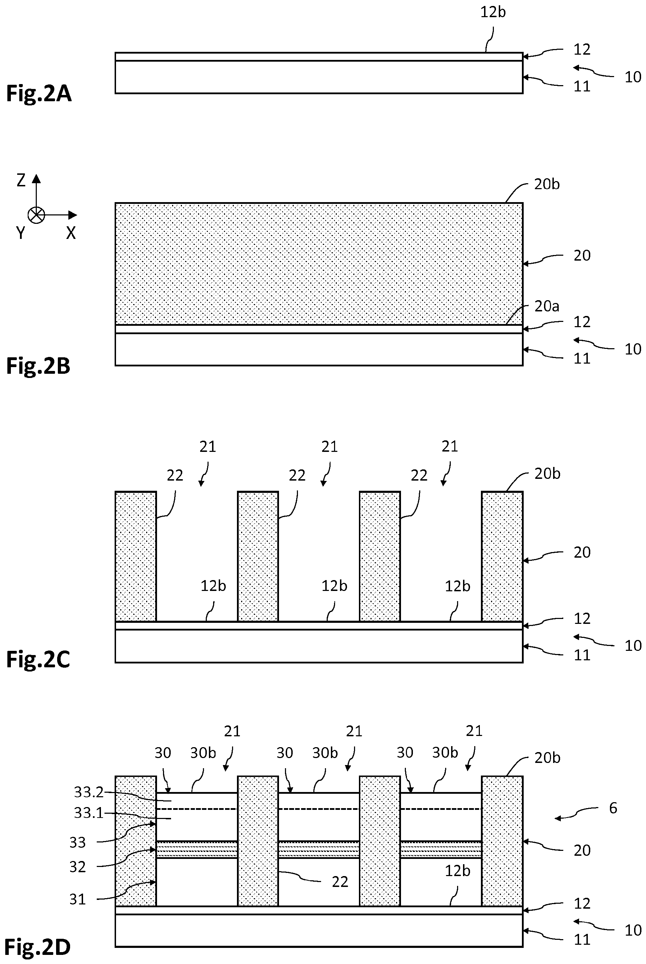

Les figures 2A à 2G sont des vues en coupe, schématiques et partielles, d'un exemple d'un procédé de fabrication d'un dispositif optoélectronique 1 à matrice de diodes 2. Dans cet exemple, les diodes 2 sont électroluminescentes et sont réalisées à base de GaN à partir d'un substrat de croissance 10 réalisé à base de silicium.

On définit ici et pour la suite de la description un repère direct orthogonal XYZ, où les axes X et Y forment un plan parallèle au plan principal du substrat de croissance 10, et où l'axe Z est orienté de manière orthogonale au plan XY. Dans la suite de la description, les termes « vertical » et « verticalement » s'entendent comme étant relatifs à une orientation sensiblement parallèle à l'axe Z. Les termes « latéral » et « latéralement » s'entendent comme étant relatifs à une orientation sensiblement parallèle ou inclinée par rapport à l'axe Z. Par ailleurs, les termes « inférieur » et « supérieur » s'entendent comme étant relatifs à un positionnement croissant lorsqu'on s'éloigne du substrat de croissance 10 suivant la direction +Z.

En référence à la fig.2A, on fournit un substrat de croissance 10 adapté à permettre la croissance épitaxiale d'empilements semiconducteurs des diodes. Il comporte une face supérieure qui définit une surface de nucléation 12b. Ce substrat de croissance 10 peut être une structure monobloc ou être formé d'un empilement de couches tel qu'un substrat de type SOI (pour *Silicon On Insulator,* en anglais).

Il peut ainsi comporter une couche de nucléation 12 reposant sur un substrat support 11. La face supérieure de la couche de nucléation 12 opposée au substrat support 11 définit ici la surface de nucléation 12b. La couche de nucléation 12 est réalisée en un matériau favorisant la nucléation et la croissance épitaxiale des empilements semiconducteurs, et peut être un nitrure ou un oxyde d'aluminium (par ex. AlN ou Al₂O₃), un nitrure de magnésium MgₓN_{y}, ou un nitrure ou un carbure d'un métal de transition, ou tout autre matériau adapté. L'épaisseur de la couche de nucléation 12 peut être de l'ordre de quelques nanomètres à quelques centaines de nanomètres. Dans cet exemple, la couche de nucléation 12 peut être en AlN. Par épaisseur, on entend la dimension d'un élément ou d'une couche suivant l'axe Z.

Le substrat support 11 peut être une structure monobloc ou multicouches. Il peut être en un composé semiconducteur IV, par exemple en silicium, en germanium, en carbure de silicium, ou en un composé III-V (tel que l'AlN ou le GaN) ou II-VI. Il peut également être en un matériau métallique ou en un matériau isolant comme le saphir. Dans cet exemple, il est réalisé à base de silicium. Par « à base de silicium », on entend que le substrat est réalisé majoritairement en silicium et que son coefficient de dilatation thermique moyen est sensiblement égal à celui du silicium. Par « réalisé majoritairement en un matériau donné », on entend un élément comprenant ledit matériau pour en moins 50% de son volume.

Le substrat de croissance 10 présente un coefficient de dilatation thermique α_{sc} qui exprime l'allongement relatif Δl/l du substrat de croissance 10 dans un plan XY parallèle au plan du substrat de croissance 10 pour une différence de température ΔT. D'une manière générale, le coefficient de dilatation thermique est défini comme α = (l₂-l₁)/(l₁.(T₂-T₁)), où l₁ et l₂ sont respectivement la largeur de l'élément considéré, c'est-à-dire une dimension dans le plan XY, à la température T₁ et T2. Dans le cas où le substrat de croissance 10 comporte plusieurs matériaux différents, on définit un coefficient de dilatation thermique moyen, qui correspond essentiellement à une pondération des coefficients de dilatation thermique des différents matériaux en fonction de leur fraction volumique. Ici, le substrat de croissance 10 est formé de plusieurs matériaux différents et son coefficient de dilatation thermique est alors un coefficient moyen α̃_{sc} pouvant être défini par la relation : α̃ = Σᵢ αᵢ vᵢ, où chaque matériau i comporte un coefficient de dilatation thermique αᵢ et une fraction volumique vi.

Le substrat de croissance 10 est tel que son coefficient de dilatation thermique moyen α̃_{sc} est inférieur au coefficient de dilatation thermique αₑₛ des empilements semiconducteurs 30. Dans cet exemple, les empilements semiconducteurs 30 sont réalisés à base d'un composé semiconducteur dit de base, c'est-à-dire qu'il est formé majoritairement de ce composé semiconducteur et que son coefficient de dilatation thermique αₑₛ est sensiblement égal au coefficient de dilatation thermique de ce composé semiconducteur. Ici, les empilements semiconducteurs 30 sont réalisés à base de GaN, de sorte que le coefficient αₑₛ est sensiblement égal à celui du GaN, c'est-à-dire à 5,6.10⁻⁶ K⁻¹ environ. Le substrat de croissance 10 est réalisé à base de silicium, c'est-à-dire qu'il comporte majoritairement du silicium et que son coefficient de dilatation moyen α̃_{sc} est sensiblement égal au coefficient de dilatation thermique du silicium α_{Si}, lequel est égal à 2,6.10⁻⁶ K⁻¹ environ.

En référence à la fig.2B, on dépose sur le substrat de croissance 10 une couche diélectrique 20 destinée à former un masque de croissance. La couche diélectrique 20 recouvre alors continûment la surface de nucléation 12b.

La couche diélectrique 20 est réalisée en au moins un matériau électriquement isolant, par exemple un oxyde ou un nitrure de silicium, tel que du SiO₂ ou du Si₃N₄, voire un oxynitrure de silicium, un oxyde d'aluminium ou un oxyde d'hafnium. Le matériau de la couche diélectrique 20 est choisi de sorte que son coefficient de dilatation thermique α_{mc} est inférieur au coefficient de dilatation thermique αₑₛ des empilements semiconducteurs 30. Dans cet exemple, la couche diélectrique 20 est réalisée en SiO₂ dont le coefficient de dilatation thermique α_{mc} est égal à 0,5.10⁻⁶ K⁻¹ environ, lequel est bien inférieur au coefficient de dilatation thermique du GaN.

La couche diélectrique 20 présente une épaisseur e_{mc} qui est de préférence sensiblement homogène en tout point de la couche. L'épaisseur est ici la distance suivant l'axe Z entre une première face 20a dite inférieure en contact avec le substrat de croissance 10, et une deuxième face 20b opposée dite supérieure. La face supérieure 20b est ainsi sensiblement parallèle à la face supérieure du substrat de croissance 10. L'épaisseur e_{mc} de la couche diélectrique 20 est avantageusement choisie de manière à être supérieure ou égale à l'épaisseur eₑₛ des empilements semiconducteurs 30 réalisés ultérieurement. La couche diélectrique 20 peut présenter une épaisseur e_{mc} comprise entre 100nm et 50µm, de préférence comprise entre 2µm et 5µm environ.

En référence à la fig.2C, on réalise ensuite, par des techniques de photolithographie et de gravure classiques, par exemple par gravure sèche de type plasma (RIE, ICP...), des ouvertures traversantes 21 dans la couche diélectrique 20, de manière à rendre localement libre des parties de la surface de nucléation 12b. La couche diélectrique 20 forme alors un masque de croissance. Les ouvertures traversantes 21 sont ainsi destinées à recevoir les empilements semiconducteurs 30.

La section des ouvertures traversantes 21 dans le plan XY peut présenter différentes formes, par exemple une forme circulaire, ovale, polygonale, par exemple triangulaire, carrée, rectangulaire voire hexagonale. Le diamètre d'une ouverture traversante 21 est ici une grandeur associée à son périmètre au niveau d'une section dans le plan XY. De préférence, le diamètre est sensiblement constant suivant l'axe Z, mais peut également varier suivant l'axe Z. Les ouvertures traversantes 21 peuvent présenter les mêmes dimensions d'une ouverture à l'autre.

Les ouvertures traversantes 21 peuvent présenter des dimensions latérales, dans le plan XY, comprises entre 500nm et quelques millimètres, selon les applications visées, et de préférence comprises entre 1µm et 10µm. La dimension transversale du masque de croissance 20 séparant deux ouvertures traversantes 21 adjacentes peut être de l'ordre de 1µm environ.

La bordure latérale 22 des ouvertures traversantes 21 relie la face supérieure 20b de la couche diélectrique 20 à la surface de nucléation 12b. Dans cet exemple, la bordure latérale 22 s'étend de manière continûment rectiligne et orthogonale entre la surface de nucléation 12b du substrat de croissance 10 et la face supérieure 20b de la couche diélectrique 20. En variante, comme décrit plus loin, les ouvertures traversantes 21 peuvent être inclinées vis-à-vis de l'axe Z, c'est-à-dire qu'elles s'étendent suivant un axe directeur incliné par rapport à l'axe Z, à partir de chaque surface de nucléation 12b. En variante, les ouvertures traversantes 21 peuvent être structurées de manière à présenter une première cavité débouchant sur une surface de nucléation 12b, et une deuxième cavité, communiquant avec la première cavité, et débouchant au niveau de la face supérieure 20b.

En référence à la fig.2D, on réalise ensuite les empilements semiconducteurs 30 dans les ouvertures traversantes 21, par croissance épitaxiale, à partir de chaque surface de nucléation 12b.

Chaque empilement semiconducteur 30 comporte une première portion 31 dopée selon un premier type de conductivité, par exemple de type n, et une deuxième portion 33 dopée selon un deuxième type de conductivité opposé au premier type, par exemple de type p, entre lesquelles est située une zone active 32. Bien entendu, les types de conductivité peuvent être inversés. Les empilements semiconducteurs 30 sont de préférence réalisés simultanément, de sorte que les portions dopées 31, 33 et la zone active 32 de chaque empilement semiconducteur 30 présentent avantageusement sensiblement les mêmes caractéristiques en termes de dimensions, de composition et de niveau de dopage.

Les empilements semiconducteurs 30 sont réalisés de sorte qu'au moins les premières portions 31 dopées n et les zones actives 32 sont situées dans les ouvertures traversantes 21. De préférence, les deuxièmes portions 33 dopées p sont entièrement situées dans les ouvertures traversantes 21, de sorte que les empilements semiconducteurs 30 présentent une épaisseur eₑₛ inférieure ou égale à l'épaisseur e_{mc} du masque de croissance 20. L'épaisseur eₑₛ est ici la dimension suivant l'axe Z séparant la face inférieure vis-à-vis de la face supérieure 30b des empilements semiconducteurs 30. La face inférieure est ici la face des premières portions 31 dopées n au contact avec le substrat de croissance 10, et la face supérieure 30b est ici la face des deuxièmes portions 33 dopées p opposée à la zone active 32.

Chaque empilement semiconducteur 30 est réalisé majoritairement à partir d'un même composé semiconducteur de base, par exemple un composé III-V comportant au moins un élément de la colonne III du tableau périodique et au moins un élément de la colonne V, un composé II-VI comportant au moins un élément de la colonne II du tableau périodique et au moins un élément de la colonne VI, voire un composé IV comportant au moins un élément de la colonne IV. A titre d'exemple, des composés III-V peuvent être des composés III-N, tels que GaN, InGaN, AlGaN, AlN, InN ou AlInGaN, voire comporter un élément de la colonne V du type arsenic ou phosphore, par exemple l'AsGa ou l'InP. Par ailleurs, des composés II-VI peuvent être CdTe, HgTe, CdHgTe, ZnO, ZnMgO, CdZnO ou CdZnMgO. Enfin, des éléments ou composés IV peuvent être utilisés, tels que Si, C, Ge, SiC, SiGe, ou GeC. Dans cet exemple, les empilements semiconducteurs 30 sont réalisés à base de GaN.

Les empilements semiconducteurs 30 peuvent être réalisés par un procédé du type dépôt chimique en phase vapeur (CVD, pour *Chemical Vapor Déposition,* en anglais), par exemple aux précurseurs organométalliques (MOCVD, pour *Metal-Organic Chemical Vapor Deposition,* en anglais) ou par un procédé de type épitaxie par jets moléculaires (MBE, pour *Molecular-Beam Epitaxy,* en anglais), du type épitaxie en phase vapeur aux hydrures (HVPE, pour *Hydride Vapor Phase Epitaxy,* en anglais). Dans cet exemple, les empilements semiconducteurs 30 sont réalisés par MOCVD. Ainsi, la croissance est sélective et les empilements semiconducteurs 30 sont formés par épitaxie à partir de la surface de nucléation 12b, et non pas à partir des bordures latérales 22.

Les empilements semiconducteurs 30 présentent une épaisseur eₑₛ de préférence inférieure ou égale à l'épaisseur e_{mc} du masque de croissance 20. Cela permet d'éviter d'avoir à supprimer une partie de la deuxième portion dopée 33 dans le cas où celle-ci viendrait en saillie hors de l'ouverture traversante 21, lors d'une étape ultérieure de planarisation. Ceci est particulièrement avantageux lorsque la deuxième portion 33 est dopée p et est formée d'une première partie 33.1 dopée p et d'une deuxième partie 33.2 surdopée p+, la première partie 33.1 étant située entre la zone active 32 et la deuxième partie 33.2 surdopée. On limite ainsi les risques de dégradation du contact ohmique entre l'anode 3 réalisée ultérieurement et la deuxième portion 33 dopée p.

Les empilements semiconducteurs 30 présentent des dimensions, notamment latérales, qui sont corrélées à celles des ouvertures traversantes 21. Ils peuvent ainsi présenter une épaisseur eₑₛ comprise entre 100nm et 50µm, de préférence comprise entre 2µm et 5µm environ ; l'épaisseur des premières portions 31 dopées n peut être comprise entre 50nm et 20µm, par exemple égale à 2µm environ ; celle de la zone active 32 peut être comprise entre 10nm et 500nm ; et celle de la deuxième portion 33 dopée p peut être comprise entre 50nm et 2µm, par exemple égale à 200nm environ. Les dimensions latérales, dans le plan XY, peuvent être comprises entre 500nm et quelques millimètres, selon les applications visées, et sont de préférence comprises entre 1µm et 10µm.

Chaque première portion dopée 31 peut être ici réalisée en GaN dopé de type n par exemple par du silicium. Elle est réalisée par épitaxie à partir de la surface de nucléation 12b et est délimitée latéralement par la bordure latérale 22 du masque de croissance 20 avec laquelle elle est en contact. La croissance étant sélective, il n'y a pas de croissance sur les bordures latérales 22.

La zone active 32 est la partie de la diode 2 au niveau de laquelle est émis ou détecté l'essentiel du rayonnement lumineux. Elle peut comprendre au moins un puits quantique réalisé en un composé semiconducteur présentant une énergie de bande interdite inférieure à celles des première et deuxième portions dopées 31, 33. Elle peut comporter un unique puits quantique ou une pluralité de puits quantiques sous la forme de couches ou de boîtes intercalées entre des couches barrières. Elle peut être intrinsèque, c'est-à-dire non intentionnellement dopée. Elle peut être ici réalisée en une alternance de couches barrières en GaN et de puits quantiques en InGaN. La zone active 32 recouvre la surface supérieure de la première portion 31 dopée n et est délimitée latéralement par la bordure latérale 22 du masque de croissance 20 avec laquelle elle est en contact.

La deuxième portion 33 dopée p peut être réalisée en le composé semiconducteur de base, c'est-à-dire ici en GaN, ou être un alliage de GaN, par exemple en InGaN. Elle est ici dopée de type p par exemple par du magnésium. Elle recouvre la surface supérieure de la zone active 32 et est ici délimitée latéralement par la bordure latérale 22 du masque de croissance 20 avec laquelle elle est en contact, notamment lorsque l'épaisseur e_{mc} du masque de croissance 20 est supérieure à l'épaisseur eₑₛ de l'empilement semiconducteur 30.

La deuxième portion 33 dopée p peut comporter en outre une couche intercalaire de blocage d'électrons (non représentée) située à l'interface avec la zone active 32. La couche de blocage d'électrons peut ici être formée d'un composé ternaire III-N, par exemple de l'AlGaN ou de l'AlInN, avantageusement dopé p. Elle permet d'accroître le taux de recombinaisons radiatives dans la zone active 32.

La deuxième portion 33 dopée p comprend avantageusement une première partie 33.1 dopée p à un premier niveau de dopage et une deuxième partie 33.2 surdopée p+, c'est-à-dire dopée p à un deuxième niveau de dopage supérieur au premier niveau de dopage. La première partie 33.1 est située entre la zone active 32 et la deuxième partie 33.2 surdopée p+. Cette partie 33.2 surdopée p+ permet d'améliorer le contact ohmique entre la deuxième portion 33 dopée p et l'électrode de polarisation 3.

Ainsi, on obtient une pluralité d'empilements semiconducteurs 30 localisés chacun dans une ouverture traversante 21 du masque de croissance 20. Le masque de croissance 20 est une couche épaisse diélectrique qui s'étend continûment entre et au contact des empilements semiconducteurs 30. Elle est dite épaisse dans le sens où au moins les premières portions 31 dopées n et les zones actives 32, et de préférence les deuxièmes portions 33 dopées p, sont situées dans les ouvertures traversantes 21 et sont latéralement en contact avec le matériau du masque de croissance 20.

Dans cet exemple, les empilements semiconducteurs 30 présentent une épaisseur eₑₛ inférieure à celle e_{mc} du masque de croissance 20, de sorte que des zones en retrait sont formées en surface des empilements semiconducteurs 30 par rapport à la face supérieure 20b du masque de croissance 20. Ces zones en retrait présentent une hauteur suivant l'axe Z égale à la différence entre l'épaisseur e_{mc} et l'épaisseur eₑₛ. Dans cet exemple, la présence des zones en retrait est mise à profit pour réaliser ultérieurement des électrodes de polarisation 3, ici des anodes, disposées en contact électrique avec les deuxièmes portions 33 dopées p.

Dans le cadre du procédé de fabrication selon l'invention, les empilements semiconducteurs 30, distincts les uns des autres, sont pixellisés dès la croissance épitaxiale, par leur réalisation dans les ouvertures traversantes 21 du masque de croissance 20, et non par gravure localisée d'un empilement semiconducteur formé de couches bidimensionnelles, comme dans l'exemple de l'art antérieur mentionné précédemment. Ainsi, on réduit les risques de dégradation de la qualité cristalline du composé semiconducteur, notamment au niveau des flancs latéraux des empilements semiconducteurs puisque la pixellisation n'est pas effectuée par gravure localisée. Les propriétés optiques et/ou électroniques du dispositif optoélectronique 1 sont ainsi améliorées.

De plus, les empilements semiconducteurs 30 sont réalisés par croissance épitaxiale dans les ouvertures traversantes 21 du masque de croissance 20, celui-ci étant une couche épaisse diélectrique au contact au moins des premières portions 31 dopées n et des zones actives 32. Ainsi, le masque de croissance 20 assure une fonction supplémentaire de passivation des flancs latéraux des empilements semiconducteurs 30, permettant de limiter l'effet d'éventuels états de surface pouvant conduire à des recombinaisons non radiatives dans la zone active 32 ou de limiter les fuites verticales. Le rendement quantique interne de la zone active 32 est alors amélioré, ce qui permet d'améliorer également les propriétés optiques et/ou électroniques du dispositif optoélectronique 1.

Par ailleurs, les empilements semiconducteurs 30 pixellisés, en association avec le masque de croissance 20, forment une structure optoélectronique 6 présentant un coefficient de dilatation thermique moyen α̃ₛₒ dont la valeur est inférieure au coefficient de dilatation thermique αₑₛ des empilements semiconducteurs 30, celui-ci étant ici sensiblement égal à celui du GaN. Le coefficient moyen α̃ₛₒ est ici sensiblement égal à une pondération du coefficient αₑₛ des empilements semiconducteurs 30 et du coefficient α_{mc} du masque de croissance 20 avec leurs fractions volumiques respectifs. Ainsi, la différence entre le coefficient de dilatation thermique moyen α̃ₛₒ de la structure optoélectronique 6 et le coefficient de dilatation thermique moyen α_{sc} du substrat de croissance 10 est diminué, réduisant ainsi l'intensité des contraintes mécaniques en tension subies par les empilements semiconducteurs 30 après la phase de refroidissement faisant suite à l'étape de croissance épitaxiale. Ces contraintes mécaniques sont également diminuées par le fait que les empilements semiconducteurs 30 sont pixellisés dès la croissance, améliorant ainsi la répartition des contraintes mécaniques au sein de la structure optoélectronique 6 générées par la phase de refroidissement. On limite ainsi le risque de génération de fissures dans le matériau des empilements semiconducteurs 30. Il est alors possible de réduire la complexité des techniques d'ingénierie de la contrainte mécanique éventuellement mises en oeuvre pour imposer une contrainte mécanique initiale en compression au matériau des empilements semiconducteurs 30 lors de la croissance épitaxiale, simplifiant ainsi le procédé de fabrication.

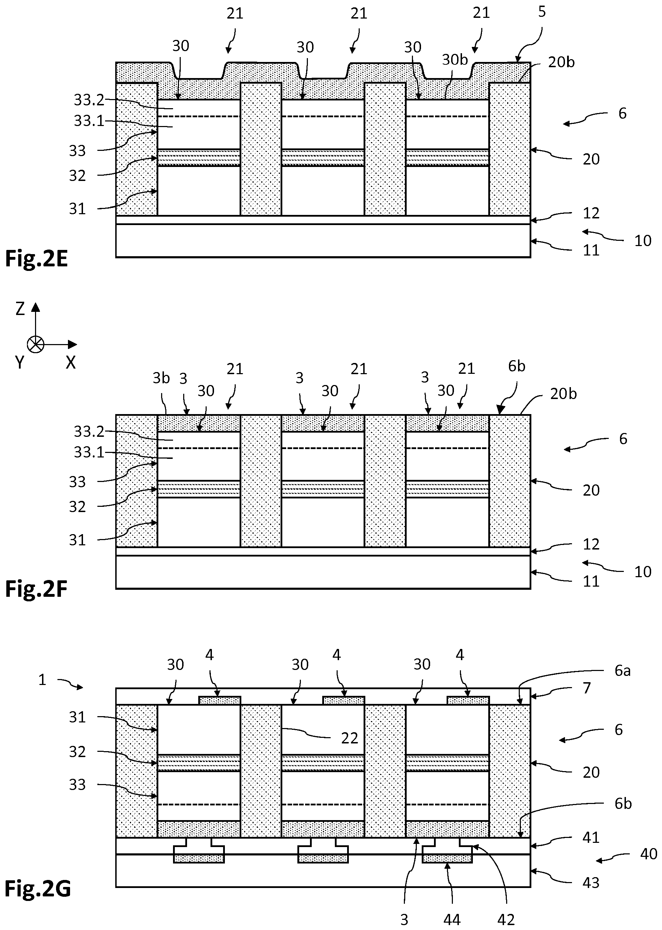

En référence à la fig.2E, on réalise ensuite des électrodes de polarisation destinées à appliquer un potentiel électrique aux deuxièmes portions 33 dopées p. Dans cet exemple, on réalise un dépôt pleine plaque d'un matériau électrique conducteur, de manière à recouvrir continûment le masque de croissance 20 et les empilements semiconducteurs 30, et à remplir les zones en retrait surplombant chaque empilement semiconducteur 30. L'épaisseur de cette couche conductrice 5 est ici supérieure ou égale à la différence entre l'épaisseur e_{mc} du masque de croissance 20 et l'épaisseur eₑₛ des empilements semiconducteurs 30.

Le matériau conducteur est ainsi en contact avec la face supérieure 20b du masque de croissance 20 et avec la face supérieure 30b des empilements semiconducteurs 30. Il peut être transparent ou réfléchissant au rayonnement électromagnétique émis par les diodes 2, selon que l'extraction lumineuse est effectuée au travers des deuxièmes portions 33 dopées p ou des premières portions 31 dopées n.

En référence à la fig.2F, on réalise une planarisation de la couche conductrice 5 afin de supprimer les parties de la couche recouvrant le masque de croissance 20, et de réaliser une face continue 6b sensiblement plane de la structure optoélectronique 6. La planarisation peut être de type mécano-chimique (CMP) et/ou de type gravure sèche. Elle est effectuée avec arrêt de gravure sur la face supérieure 20b du masque de croissance 20. Ainsi, on obtient une pluralité d'électrodes de polarisation 3, ici des anodes, distinctes les unes des autres, et mutuellement séparées par le masque de croissance 20. Ces électrodes de polarisation 3 sont ici nommées deuxièmes électrodes et sont en contact avec les deuxièmes portions 33 dopées p. Des premières électrodes (cathodes) sont destinées à être réalisées en contact électrique avec les premières portions 31 dopées n. La face supérieure 6b de la structure optoélectronique 6 est continue et sensiblement plane, et est formée par la face supérieure 20b du masque de croissance 20, laquelle est rendue libre, c'est-à-dire non recouverte par un autre matériau, et par la face supérieure 3b des deuxièmes électrodes 3.

En référence à la fig.2G, on réalise une hybridation de la structure optoélectronique 6 avec une puce de commande 40. Par hybridation, on entend un assemblage mécanique et une connexion électrique. Le caractère sensiblement plan de la face supérieure 6b de la structure optoélectronique 6 permet de réaliser une hybridation sur la puce de commande 40, notamment par collage direct. La face supérieure 6b de la structure optoélectronique 6 forme ici une face arrière de connexion électrique, la face avant opposée 6a correspondant à la face d'émission.

La puce de commande 40 comporte ici une couche 41 de raccord électrique (facultative) intercalée entre la structure optoélectronique 6 et une couche de circuit intégré 43, permettant de faciliter la connexion électrique. La couche de raccord 41 comporte ainsi des éléments 42 de connexion électrique assurant la connexion entre les deuxièmes électrodes 3 avec des portions conductrices 44 de la couche de circuit intégré 43. Les éléments de connexion 42 sont électriquement isolés les uns des autres par un matériau diélectrique. La couche de raccord 41 présente ici une épaisseur sensiblement constante.

La couche de circuit intégré 43 est assemblée à la face arrière 6b de la structure optoélectronique 6, ici par le biais de la couche de raccord. La puce de commande 40 assure notamment la connexion électrique des diodes 2 de manière à commander l'émission lumineuse par les diodes électroluminescentes. Ainsi, les portions conductrices 44 permettent ici la polarisation en direct des diodes électroluminescentes 2. La puce de commande 40 peut également comporter les éléments électroniques, de type transistors, assurant la commande d'émission des diodes électroluminescentes. Alternativement, elle peut être un composant passif ne comportant essentiellement que des lignes de connexion électrique reliant les portions conductrices 44 à des éléments électroniques déportés.

La fixation de la structure optoélectronique 6 avec la puce de commande 40 peut être assurée par collage direct, également appelée collage par adhérence moléculaire, entre le matériau conducteur des deuxièmes électrodes 3 et le matériau conducteur des éléments de connexion 42 de la couche de raccord le cas échéant. Alternativement, une fixation par des microbilles ou des micro-tubes de connexion électriques et/ou par thermocompression peut également être effectuée.

De plus, on supprime ici le substrat de croissance 10, par exemple par planarisation mécano-chimique, par gravure sèche, par laser (LLO, pour *Laser Lift-Off,* en anglais) ou par abrasion, de manière à exposer la face inférieure des premières portions 31 dopées n ainsi que la face inférieure du masque de croissance 20. La face inférieure 6a de la structure optoélectronique 6 est ici continue et sensiblement plane, et forme dans cet exemple la face d'émission du dispositif optoélectronique 1.

On réalise ensuite des premières électrodes 4 de polarisation en contact électrique avec les premières portions 31 dopées n. Cette étape est effectuée par dépôt, photolithographie et gravure, d'un matériau électriquement conducteur et transparent au rayonnement électromagnétique émis par les diodes 2, par exemple de l'oxyde d'indium étain (ITO, pour *Indium Tin Oxide*) ou du ZnO. Ces premières électrodes 4 peuvent présenter une épaisseur de quelques nanomètres à quelques dizaines ou centaines de nanomètres. Les électrodes 4 peuvent se présenter sous la forme de plots distincts ou être des zones d'une même couche continue.

Une couche de protection 7, réalisée en un matériau diélectrique et transparent au rayonnement électromagnétique, peut ensuite être déposée sur la face d'émission 6a de la structure optoélectronique 6, de manière à assurer une protection structurelle des diodes 2.

On obtient ainsi un dispositif optoélectronique 1, dont la structure optoélectronique 6 comporte une matrice de diodes 2 localisées dans les ouvertures traversantes 21 du masque de croissance 20 et isolées les unes des autres par ce dernier. Au moins les premières portions 31 dopées n et les zones actives 32, et de préférence également les deuxièmes portions 33 dopées p, sont situées dans ces ouvertures traversantes 21 et en contact avec la bordure latérale 22 du masque de croissance 20. Celui-ci permet non seulement la croissance localisée des empilements semiconducteurs 30 et assure également la passivation des flancs latéraux des empilements semiconducteurs 30. Comme décrit précédemment, le dispositif optoélectronique 1 présente une bonne qualité cristalline du matériau des empilements semiconducteurs 31, améliorant ainsi ses propriétés optiques et/ou électroniques.

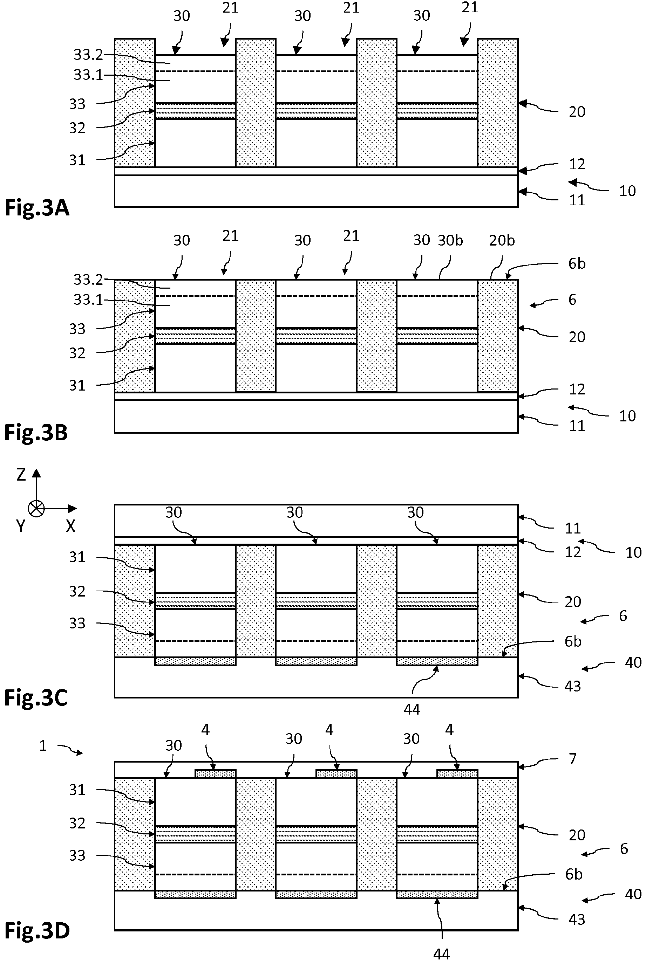

Les figures 3A à 3D illustrent, de manière schématique et partielle, certaines étapes d'un procédé de fabrication d'un dispositif optoélectronique 1 selon un autre exemple. Dans cet exemple, le procédé diffère de celui illustré sur les fig.2A à 2G essentiellement en ce qu'il ne comporte pas d'étape de réalisation des deuxièmes électrodes 3 avant l'hybridation à la puce de commande 40.

La fig.3A illustre la structure obtenue à la suite de la réalisation des empilements semiconducteurs 30 par croissance épitaxiale dans les ouvertures traversantes 21. Cette structure est identique ou similaire à celle décrite en référence à la fig.2D et les étapes antérieures de fabrication ne sont pas décrites à nouveau.

La fig.3B illustre une étape de planarisation de la face supérieure 6b de la structure optoélectronique 6. Pour cela, on planarise le masque de croissance 20, par polissage mécano-chimique et/ou gravure, avec arrêt de gravure sur la face supérieure 30b des empilements semiconducteurs 31. Ainsi, la structure optoélectronique 6 présente une face supérieure 6b continue et sensiblement plane, définie par la face supérieure 20b du masque de croissance 20 et la face supérieure 30b des empilements semiconducteurs 31, ces faces supérieures 20b, 30b étant sensiblement coplanaires.

La fig.3C illustre l'hybridation de la structure optoélectronique 6 ainsi obtenue à une puce de commande 40. Le caractère sensiblement plan de la face supérieure 6b de la structure optoélectronique 6 permet d'effectuer l'hybridation, par exemple par collage direct.

Dans cet exemple, la puce de commande 40 comporte une couche de circuit intégré 43 dont la face de connexion comporte des portions conductrices 44. Comme mentionné précédemment, ces dernières peuvent être reliées à des éléments électroniques, de type transistors, assurant la commande d'émission des diodes électroluminescentes, ces éléments électroniques pouvant être situés dans la puce de commande ou être des éléments déportés. Les portions conductrices 44 peuvent être des plots distincts, ou être des zones d'une même couche continue.

La fixation de la structure optoélectronique 6 avec la puce de commande 40 est ici assurée par collage direct entre le composé semiconducteur des deuxièmes portions 33 dopées p et le matériau conducteur des portions conductrices 44 de la puce de commande 40. Une couche de raccord (non représentée), identique ou similaire à celle décrite sur la fig.2G, peut être intercalée entre la structure optoélectronique 6 et la couche de circuit intégré 43 de la puce de commande 40.

La fig.3D illustre la suppression du substrat de croissance 10 de manière à rendre libre la face inférieure 6a de la structure optoélectronique 6, devenant ainsi la face d'émission. Les premières électrodes 4 de polarisation sont ensuite réalisées de manière à être en contact électrique avec les premières portions 31 dopées n, puis le dépôt de la couche de protection 7 est effectué. Ces étapes ont été décrites précédemment et ne sont pas détaillées à nouveau.

Ainsi, on obtient un dispositif optoélectronique 1 dans lequel le collage direct est effectué entre les deuxièmes portions 33 dopées p de la structure optoélectronique 6 et les portions conductrices 44 de la puce de commande 40. Cette étape d'hybridation par collage direct est rendue possible par la planarisation préalable de la face supérieure 6b de la structure optoélectronique 6, effectuée après l'étape de croissance épitaxiale des empilements semiconducteurs 30, de manière à réduire l'épaisseur e_{mc} du masque de croissance 20.

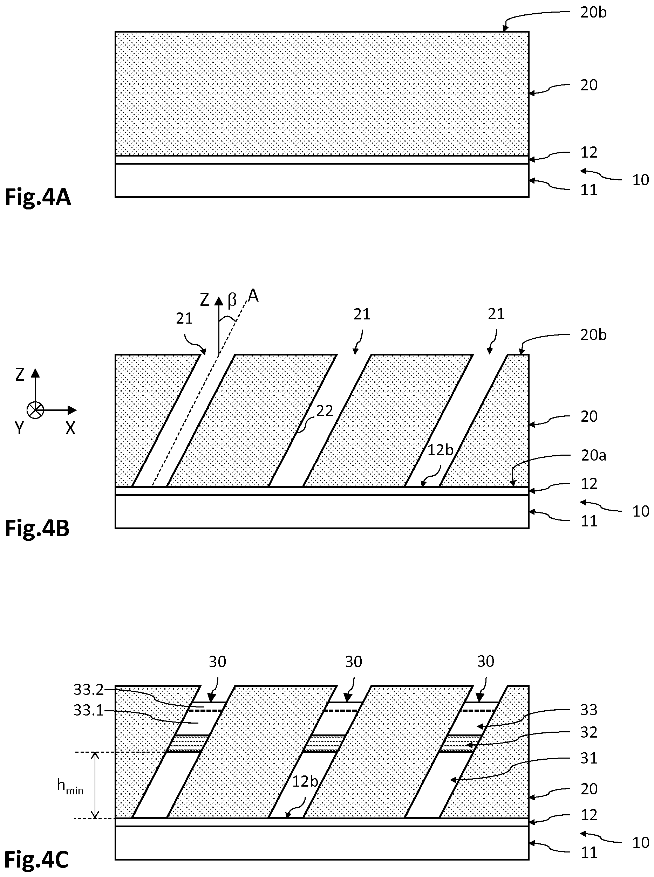

Les figures 4A à 4C illustrent, de manière schématique et partielle, certaines étapes d'un procédé de fabrication d'un dispositif optoélectronique 1 selon un autre exemple. Dans cet exemple, le procédé diffère de celui illustré sur les fig.2A à 2G essentiellement en ce que les ouvertures traversantes 21 de la couche diélectrique 20 s'étendent de manière inclinée à rapport à l'axe Z.

La fig.4A illustre le dépôt de la couche diélectrique 20 sur le substrat de croissance 10. Cette étape est identique ou similaire à celle décrite en référence à la fig.2B.

La fig.4B illustre la réalisation d'ouvertures traversantes 21 au travers de la couche diélectrique 20, par exemple par gravure sèche de type RIE. Chaque ouverture traversante 21 s'étend à partir de la face supérieure 20b de la couche diélectrique 20 jusqu'à déboucher sur la surface de nucléation 12b. La couche diélectrique 20 forme alors un masque de croissance.

Les ouvertures traversantes 21 sont ici inclinées par rapport à l'axe Z, c'est-à-dire qu'elles s'étendent suivant un axe directeur A, lequel forme un angle β non nul par rapport à l'axe Z. D'une manière générale, l'axe directeur A d'une ouverture traversante 21 est une droite passant par le centre des sections planes de l'ouverture traversante 21 parallèles au plan XY. Une section plane est ici une intersection entre l'ouverture traversante 21 et un plan parallèle au plan XY. La section plane dite inférieure, respectivement supérieure, est celle qui est située au niveau de la face inférieure 20a, respectivement supérieure 20b, du masque de croissance 20. La section plane inférieure débouche ici sur la surface de nucléation 12b de l'ouverture traversante 21 considérée.

Dans cet exemple, les ouvertures traversantes 21 sont toutes inclinées suivant le même angle β. Par ailleurs, la bordure latérale 22 de chaque ouverture est sensiblement rectiligne, et est ici sensiblement parallèle à l'axe directeur A. Dans la réalité, les formes obtenues pourront être moins régulières et rectilignes, mais s'approcheront des formes illustrées sur la fig.4B. En variante, la bordure latérale 22 peut ne pas être parallèle à l'axe directeur A, notamment lorsque l'ouverture traversante 21 présente une forme conique.

L'angle d'inclinaison β des ouvertures traversantes 21 est avantageusement choisi de sorte que la section plane supérieure n'est pas située à l'aplomb, c'est-à-dire à la perpendiculaire, de la surface de nucléation 12b correspondante. Autrement dit, la section plane supérieure et la section plane inférieure ne sont pas sécantes, en projection suivant l'axe Z. De préférence, comme illustré sur la fig.4B, l'angle d'inclinaison β est choisi de sorte qu'à partir d'une section plane dite minimale, située à la hauteur hₘᵢₙ vis-à-vis de la surface de nucléation 12b suivant l'axe Z, les sections planes ne sont pas situées à l'aplomb de la surface de nucléation 12b correspondante. Ainsi, chaque zone active 32 se trouve avantageusement à une distance de la surface de nucléation 12b, suivant l'axe Z, supérieure ou égale à hₘᵢₙ.

La fig.4C illustre la réalisation des empilements semiconducteurs 30 dans les ouvertures traversantes 21. Comme décrit précédemment, les premières portions 31 dopées n sont réalisées à partir de la surface de nucléation 12b de chaque ouverture traversante 21, par exemple par MOCVD. Elles présentent avantageusement une épaisseur au moins égale à la hauteur minimale hₘᵢₙ. Rappelons que l'épaisseur est ici une dimension mesurée suivant l'axe Z. Les zones actives 32 sont formées à partir des premières portions 31 dopées n, puis les deuxièmes portions 33 dopées p sont réalisées.

Ainsi, dans cet exemple, la zone active 32 est située à une distance, suivant l'axe Z, au moins égale à la hauteur hₘᵢₙ, de sorte qu'elle n'est pas située à l'aplomb de la surface de nucléation 12b. Cette configuration est particulièrement avantageuse dans la mesure où elle permet d'éviter que des défauts structuraux tels que des dislocations traversantes *(threading dislocations,* en anglais) ne puissent pas se propager verticalement jusqu'à la zone active 32. Cela concerne notamment le cas où les empilements semiconducteurs 30 sont réalisés à base d'un composé III-N dont la maille cristalline est de type wurtzite (hexagonal). Le rendement quantique interne de la zone active 32, et donc les propriétés optiques et/ou électroniques du dispositif optoélectronique 1, sont alors améliorés.

Dans le cas où le masque de croissance 20 surplombe au moins en partie la zone active 32, le matériau du masque de croissance 20 est en outre choisi pour être transparent au rayonnement électromagnétique émis ou détecté par les diodes.

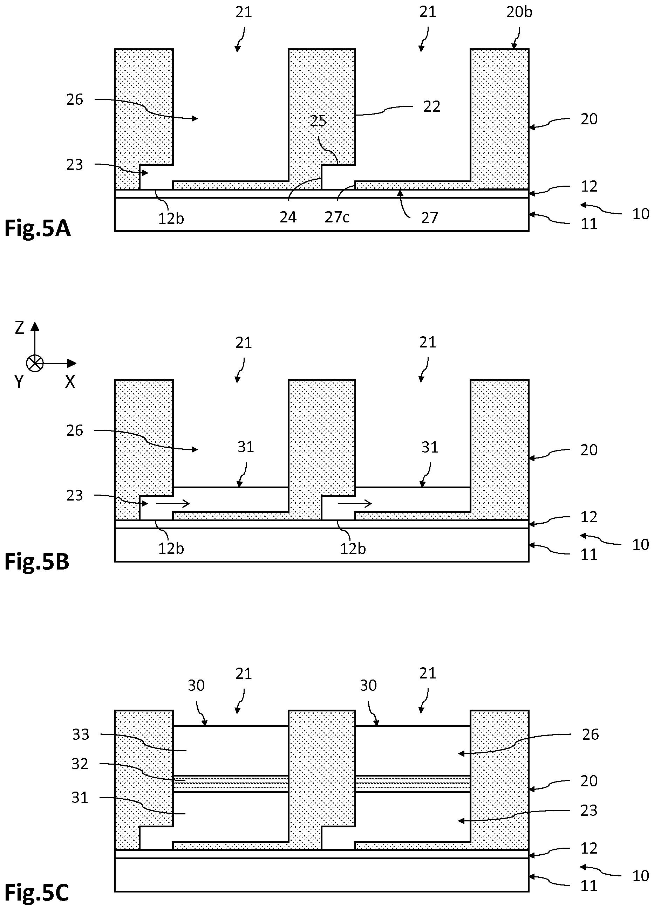

Les figures 5A à 5C illustrent, de manière schématique et partielle, certaines étapes d'un procédé de fabrication d'un dispositif optoélectronique 1 selon un exemple. Dans cet exemple, le procédé diffère de celui illustré sur les fig.4A à 4C essentiellement en ce que les ouvertures traversantes 21 sont structurées de manière à former plusieurs cavités 23, 26 distinctes et communiquant les unes avec les autres.

La fig.5A illustre la réalisation des ouvertures traversantes 21 structurées. Dans cet exemple, chaque ouverture traversante 21 comporte une cavité inférieure 23 débouchant sur la surface de nucléation 12b, et une cavité supérieure 26 débouchant sur la face supérieure 20b du masque de croissance 20. Les deux cavités 23, 26 communiquent entre elles. D'une manière générale, les ouvertures traversantes 21 structurées peuvent comporter plus de deux cavités distinctes. Les différentes cavités 23, 26 peuvent être réalisées en différents temps, lors de l'étape de réalisation du masque de croissance 20, par des étapes classiques de dépôt, photolithographie et gravure.

La cavité inférieure 23 est ici délimitée suivant la direction -Z par la surface de nucléation 12b, suivant la direction +Z par une surface supérieure 25 du masque de croissance 20 opposée à la surface de nucléation 12b, et est partiellement délimitée latéralement, d'une part, par une surface latérale 24 du masque de croissance 20 qui s'étend jusqu'à la surface supérieure 25, et d'autre part, par une surface latérale 27c d'une partie inférieure 27 du masque de croissance 20. Elle est délimitée latéralement de manière partielle et non pas totale pour ainsi pouvoir communiquer avec la cavité supérieure 26.

La cavité supérieure 26 est délimitée latéralement par la bordure latérale 22, et suivant la direction -Z par la partie inférieure 27 du masque de croissance 20. Cette partie inférieure 27 repose ici sur le substrat de croissance 10. Dans cet exemple, il est avantageux que la cavité supérieure 26 soit décalée latéralement par rapport à la cavité inférieure 23 de telle sorte que des dislocations traversantes générées dans la cavité inférieure 23 ne puissent se propager verticalement dans la cavité supérieure 26. Pour cela, la surface supérieure 25 de la cavité inférieure 23 s'étend dans le plan XY de manière à être à l'aplomb de toute la surface de nucléation 12b sous-jacente. De préférence, la surface 25 recouvre une partie de la partie inférieure 27, c'est-à-dire qu'elle est située en partie en regard de la partie 27.

La fig.5B illustre une phase de croissance épitaxiale des premières portions 31 dopées n à partir de la surface de nucléation 12b de chaque ouverture traversante 21. Chaque première portion 31 dopée n nuclée à partir de la surface de nucléation 12b située dans la cavité inférieure 23, croît jusqu'à remplir progressivement la cavité inférieure 23 et à s'introduire dans la cavité supérieure 26, puis continue de croître en remplissant progressivement la cavité supérieure 26.

Lors de la croissance épitaxiale, les conditions de fonctionnement du réacteur d'épitaxie peuvent être modifiées pour favoriser une croissance verticale par rapport à la croissance latérale, ou inversement. Il peut ainsi s'agir, dans le cas de la croissance d'un composé III-V par MOCVD, de la pression dans le réacteur, du rapport V/III entre le flux molaire de l'élément V et le flux molaire de l'élément III, et/ou du rapport H₂/N₂ entre le flux de H2 sur le flux de N2. Ainsi, les conditions de croissance peuvent être tout d'abord imposées de manière à favoriser la croissance verticale jusqu'à remplir l'essentiel de la cavité inférieure 23, puis peuvent être modifiées de manière à favoriser la croissance latérale de manière à s'étendre progressivement dans la cavité supérieure 26, et peuvent ensuite être modifiées de manière à favoriser à nouveau la croissance verticale de manière à terminer la formation des premières portions 31 dopées n, et à réaliser les zones actives 32 puis les deuxièmes portions 33 dopées p.

La fig.5C illustre la structure obtenue à la suite de l'étape de réalisation des empilements semiconducteurs 30, après l'épitaxie des zones actives 32 et celle des deuxièmes portions 33 dopées p dans la cavité supérieure 26 des ouvertures traversantes 21. Ainsi, par le décalage latéral de la cavité supérieure 26 par rapport à la cavité inférieure 23, on limite voire évite que des défauts structuraux formés dans la cavité inférieure 23, tels que les dislocations traversantes, ne puisse se propager verticalement jusqu'à la zone active 32. La qualité cristalline de la zone active 32 est ainsi améliorée, ce qui augmente alors son rendement quantique interne et améliore les propriétés optiques et/ou électroniques du dispositif optoélectronique 1.

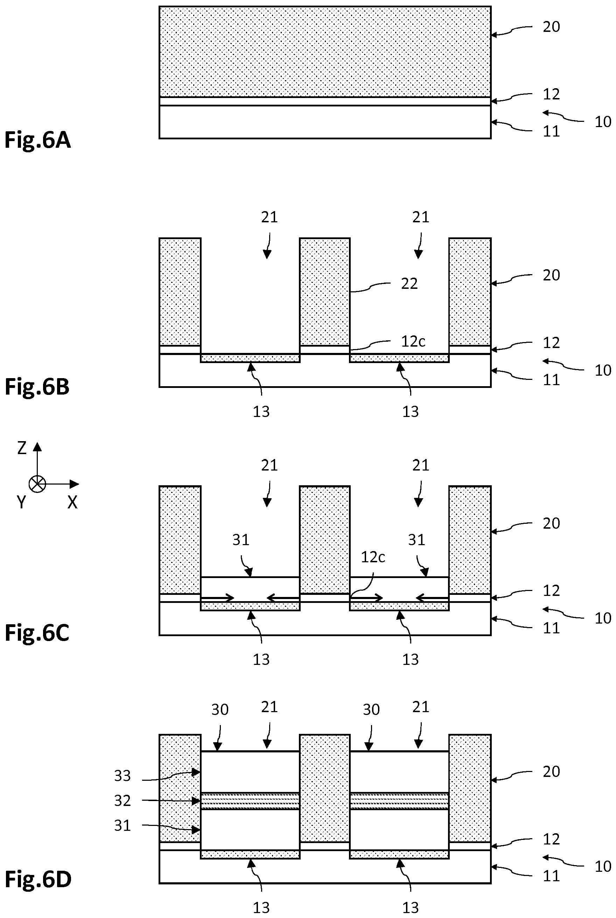

Les figures 6A à 6D illustrent, de manière schématique et partielle, certaines étapes d'un procédé de fabrication d'un dispositif optoélectronique 1 selon un mode de réalisation. Dans cet exemple, le procédé diffère de celui illustré sur les fig.2A à 2G essentiellement en ce que les ouvertures traversantes 21 sont délimitées suivant la direction -Z par une région diélectrique 13 du substrat de croissance 10 et non par une surface de nucléation 12b ou par une partie 27 du masque de croissance 20.

La fig.6A illustre le dépôt de la couche diélectrique 20 sur le substrat de croissance 10. Cette étape est identique ou similaire à celle décrite en référence à la fig.2B. Dans cet exemple, le substrat de croissance 10 est formé d'une couche de nucléation 12 qui revêt la face supérieure du substrat support 11, lequel est réalisé ici à base de silicium.

La fig.6B illustre la structure obtenue après réalisation des ouvertures traversantes 21. Ces dernières sont délimitées suivant la direction -Z par la face supérieure du substrat support 11, formé ici par la face supérieure d'une région diélectrique 13 qui s'étend dans le substrat support 11. Elles sont délimitées latéralement par une face latérale 12c de la couche de nucléation 12 et par la bordure latérale 22 du masque de croissance 20. Ainsi, la surface de nucléation qui débouche dans les ouvertures traversantes 21 est la bordure latérale 12c de la couche de nucléation 12, qui s'étend ici suivant l'axe Z d'une part, et suivant le périmètre de l'ouverture traversante 21 d'autre part.

Pour cela, les ouvertures traversantes 21 peuvent être formées par gravure sèche de type RIE, avec arrêt de gravure sur la face supérieure du substrat support 11. Dans cet exemple, le substrat support 11 étant réalisé à base de silicium, et de préférence est une couche de silicium, la région diélectrique 13 peut être obtenue par oxydation thermique ou nitruration localisée du silicium du substrat support 11. La région diélectrique 13 est alors essentiellement formée de nitrure de silicium ou d'oxyde de silicium. La profondeur de la région diélectrique 13 peut être comprise entre 5nm et 100nm, de préférence supérieure ou égale à 10nm.

L'étape de nitruration peut être réalisée avec de l'ammoniac, dans un four dédié ou dans le réacteur d'épitaxie. L'étape d'oxydation thermique peut être réalisée avec de l'oxygène ou de la vapeur d'eau, dans un four dédié. Cette étape peut comporter une exposition de la structure à une température égale à 1000°C environ, pendant une durée allant de quelques minutes à une heure.

La fig.6C illustre une phase de croissance épitaxiale des premières portions 31 dopées n à partir de la face de nucléation 12c dans chaque ouverture traversante 21. Ainsi, il est avantageux, dans le cas de la croissance d'un composé III-V par MOCVD, que les conditions de nucléation et de croissance soient définies de manière à favoriser initialement la croissance latérale du composé semiconducteur dans le plan XY. Lorsqu'une zone inférieure de l'ouverture traversante 21 est remplie par la première portion 31 dopée n, les conditions de croissance peuvent être modifiées de manière à favoriser la croissance verticale.

La fig.6D illustre la structure obtenue à la suite de l'étape de réalisation des empilements semiconducteurs 30, après l'épitaxie des zones actives 32 et celle des deuxièmes portions 33 dopées p des ouvertures traversantes 21.

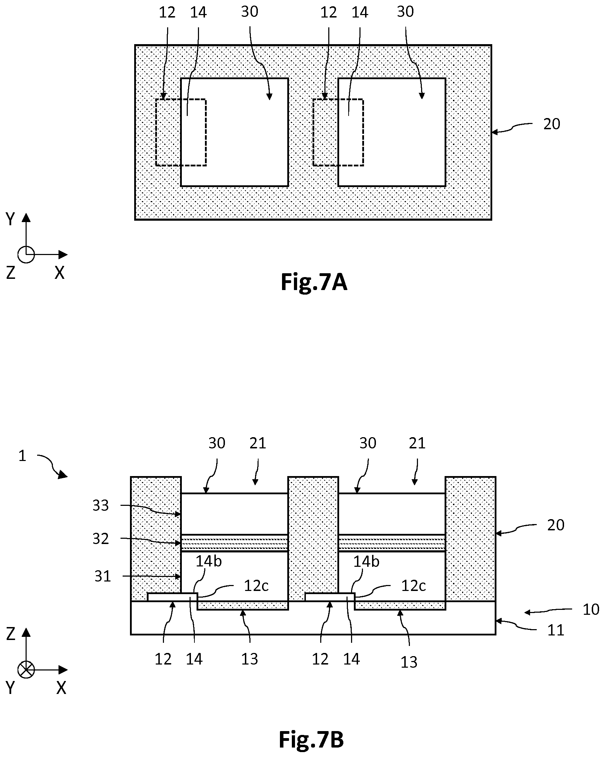

Les figures 7A et 7B illustrent, de manière schématique et partielle, un dispositif optoélectronique 1, en vue de dessus (fig.7A) et en coupe transversale (fig.7B) obtenu par procédé de fabrication selon une variante du mode de réalisation illustré sur les fig.6A à 6D. Dans cet exemple, le procédé diffère de celui illustré sur les fig. 6A à 6D essentiellement en ce qu'une partie en saillie 14 de la couche de nucléation 12 s'étend dans l'ouverture traversante 21, et n'est donc pas recouverte par le masque de croissance 20. La partie en saillie 14 s'étend dans l'ouverture traversante 21 que sur une portion de son périmètre.

Ainsi, les ouvertures traversantes 21 sont délimitées suivant la direction -Z par la région diélectrique 13 et par la partie en saillie 14 de la couche de nucléation 12. Elles sont délimitées latéralement essentiellement par la bordure latérale 22 du masque de croissance 20.

Lors de la croissance épitaxiale des premières portions 31 dopées n, la nucléation a lieu essentiellement sur la face supérieure 14b de la partie en saillie 14 de la couche de nucléation 12. Les premières portions 31 dopées n peuvent croître verticalement et latéralement, suivant les conditions de croissance imposées. Il est avantageux que la croissance soit initialement principalement latérale. Lorsque les premières portions 31 dopées n remplissent une zone inférieure des ouvertures traversantes 21, les conditions de croissance peuvent être modifiées de manière à favoriser la croissance verticale.

Ainsi, on améliore la qualité cristalline du matériau de l'empilement semiconducteur, en évitant la coalescence du composé semiconducteur qui a été nucléé à partir d'une surface de nucléation 12b telle que l'illustre la fig.6C, c'est-à-dire via une face de nucléation 12c qui s'étend suivant tout le périmètre de l'ouverture traversante 21, une telle coalescence pouvant se traduire par la formation de défauts structuraux.

De préférence, chaque ouverture traversante 21 comporte une seule surface de nucléation 12b, et non pas plusieurs surfaces de nucléation 12b distinctes les unes des autres. De plus, la surface de nucléation 12b s'étend sur une partie du contour de l'ouverture traversante 21, et non pas sur tout le contour de celle-ci. Par ailleurs, la face latérale de nucléation 12c s'étend, dans un plan XY parallèle au plan du substrat support 11, de manière convexe ou continûment rectiligne. Ainsi, on évite que le composé semiconducteur nuclée à partir de différentes surfaces de nucléation 12b distinctes, qui peuvent être orientées l'une vers l'autre (cas notamment d'une surface de nucléation concave), ce qui peut conduire ensuite à une coalescence du composé semiconducteur susceptible de générer des défauts structuraux s'étendant jusqu'à la zone active. On améliore ainsi les propriétés optiques et/ou électroniques des diodes 2.

En effet, dans le cas où la surface de nucléation 12b s'étend sur une partie du contour de l'ouverture traversante 21 mais présente une forme concave, par exemple une forme en L ou en U, il est possible que le composé semiconducteur nuclée et croisse à partir des extrémités du L ou du U, pour ensuite coalescer et former des défauts structuraux pouvant s'étendre jusqu'à la zone active. La surface de nucléation 12b peut ainsi présenter une forme de L lorsqu'elle s'étend le long de deux flancs adjacents de l'ouverture traversante 21, et peut présenter une forme de U lorsqu'elle s'étend le long de trois flancs.

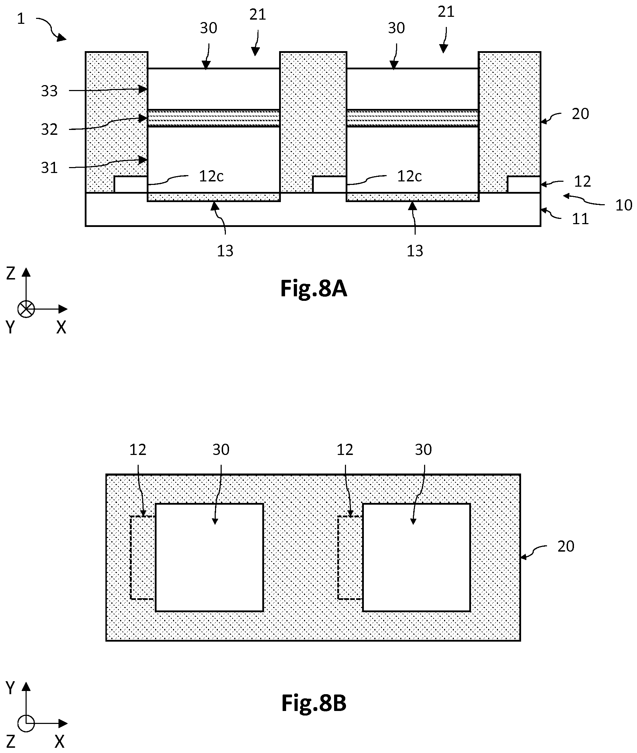

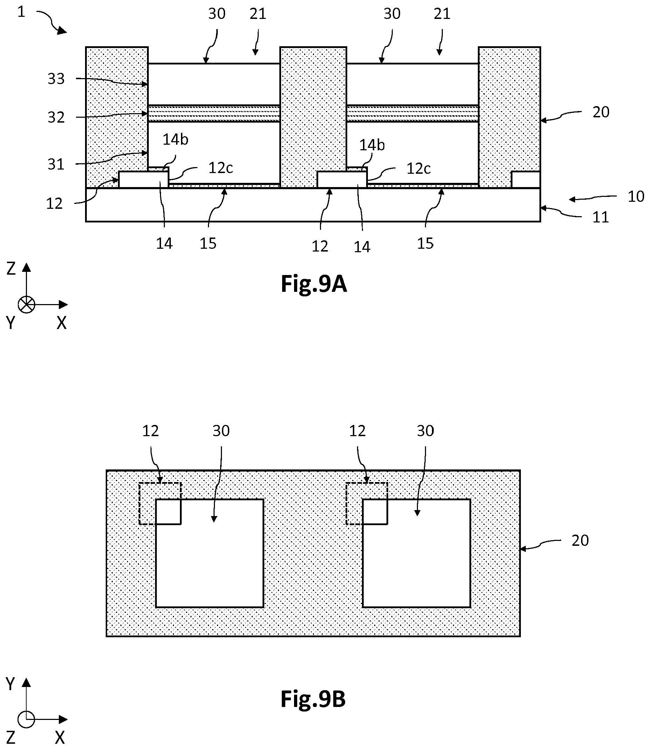

Par souci de clarté, notons que la surface de nucléation 12b peut être formée par la seule face latérale de nucléation 12c. C'est le cas notamment lorsque celle-ci affleure la bordure latérale 22 : fig.6A-6D et fig.8A-8B. C'est le cas également lorsque la partie en saillie 14 présente une face supérieure revêtue par une couche mince diélectrique 15 : fig.9A-9B. En variante, la surface de nucléation 12b peut être formée par la face latérale de nucléation 12c ainsi que par la face supérieure 14b de la partie en saillie 14 : fig.7A-7B.

Les figures 8A et 8B sont des vues schématiques et partielles d'un dispositif optoélectronique 1 selon une variante de celui illustré sur les fig.6A-6D, qui s'en distingue notamment en ce que la face latérale de nucléation 12c s'étend sur une partie seulement du contour de l'ouverture traversante 21, de manière continûment rectiligne dans le plan XY (aux incertitudes technologiques près).

Dans ce cas, la face latérale 12c affleure la bordure latérale 22 de la couche diélectrique 20 suivant l'axe Z, et s'étend dans le plan XY de manière continûment rectiligne. Autrement dit, la face latérale 12c reste contenue dans un même plan : un segment [AB] formé de deux points quelconques de la face latérale 12c reste contenu dans la face latérale 12c. La surface de nucléation 12b n'est alors pas en saillie dans l'ouverture traversante 21. L'ouverture traversante 21 présente alors une forme polygonale dans le plan XY et non pas circulaire, et la face latérale 12c s'étend de manière rectiligne (non courbe) sur un seul flanc de l'ouverture traversante 21, partiellement ou entièrement. Ainsi, la face latérale 12c ne s'étend pas sur deux flancs adjacents de l'ouverture traversante 21, auquel cas la surface de nucléation 12b aurait présenté une forme sensiblement concave (non convexe) pouvant permettre une coalescence du composé semiconducteur épitaxié, laquelle est susceptible de former des défauts structuraux pouvant dégrader la zone active.

Le composé semiconducteur est donc épitaxié à partir de la face latérale 12c qui s'étend sur une partie du contour de l'ouverture traversante 21 d'une manière continûment rectiligne, ce qui permet d'éviter les risques de coalescence du composé semiconducteur épitaxié susceptible de générer des défauts structuraux pouvant dégrader la zone active. Par ailleurs, dans cet exemple, la surface de fond, qui délimite l'ouverture traversante 21 suivant la direction -Z, est formée ici par une zone oxydée ou nitrurée du silicium du substrat support 11. En variante, elle peut être définie par une couche mince diélectrique, par exemple un nitrure de silicium ne recouvrant que le substrat support 11, et ne recouvrant pas entièrement la face latérale 12c.

Les figures 9A et 9B sont des vues schématiques et partielles d'un dispositif optoélectronique 1 selon une variante de celui illustré sur les fig.7A-7B. Dans ces deux exemples, chaque ouverture traversante 21 comporte une seule surface de nucléation 12b, qui s'étend sur une partie du contour de l'ouverture traversante 21. De plus, la face latérale de nucléation 12c s'étend dans le plan XY de manière convexe (aux incertitudes technologiques près).

La surface de nucléation 12b comporte alors une partie en saillie 14 dans l'ouverture traversante 21, qui forme un ensemble convexe au sens mathématique du terme. Autrement dit, la partie en saillie 14 de la surface de nucléation 12b, s'étend dans le plan XY, dans l'ouverture traversante 21, de telle sorte que, pour deux points quelconques A et B de la partie en saillie 14, le segment [AB] qui les joint y est entièrement contenu. L'ouverture traversante 21 peut présenter une forme polygonale ou arrondie (ovale, circulaire...) dans le plan XU. Dans le cas d'une forme polygonale, la surface de nucléation peut s'étendre le long d'un ou plusieurs flancs de l'ouverture traversante 21, partiellement ou entièrement. Quoi qu'il en soit, la surface de nucléation 12b forme un ensemble forme convexe, minimisant ainsi les risques de coalescence du composé semiconducteur épitaxié pouvant former des défauts structuraux susceptibles de dégrader la zone active.

Ainsi, sur les fig. 9A et 9B, la surface de nucléation 12b est formée par une partie en saillie 14 qui s'étend partiellement le long de deux flancs adjacents de l'ouverture traversante 21, et est localisée dans un coin de celle-ci. Elle présente une forme convexe, tout comme celle illustrée sur la fig.7A et 7B. L'ouverture traversante 21 ne comporte qu'une surface de nucléation 12b et non pas plusieurs surfaces de nucléation 12b distinctes les unes des autres.

Cependant, alors que dans l'exemple des fig.7A et 7B, la surface de nucléation 12b est formée par la face supérieure 14b et par la face latérale 12c, dans l'exemple de la fig.9A et 9B, elle est formée uniquement par la face latérale 12c. En effet, la face supérieure 14b de la partie en saillie 14 est revêtue par une couche mince diélectrique 15, par exemple un nitrure de silicium, laquelle forme également la région diélectrique 13. Cette couche mince diélectrique 15 ne revêt pas entièrement le flanc vertical de la partie en saillie 14, de sorte que la surface libre définit la face latérale de nucléation 12c.

Ainsi, le composé semiconducteur est donc épitaxié à partir de la face latérale 12c de la partie en saillie 14 de la surface de nucléation 12b, située dans un coin de l'ouverture traversante 21, laquelle présente alors une forme convexe et non pas concave (pas en forme, par exemple, de L ou de U), ce qui permet d'éviter les risques de coalescence du composé semiconducteur épitaxié susceptible de générer des défauts structuraux pouvant dégrader la zone active.

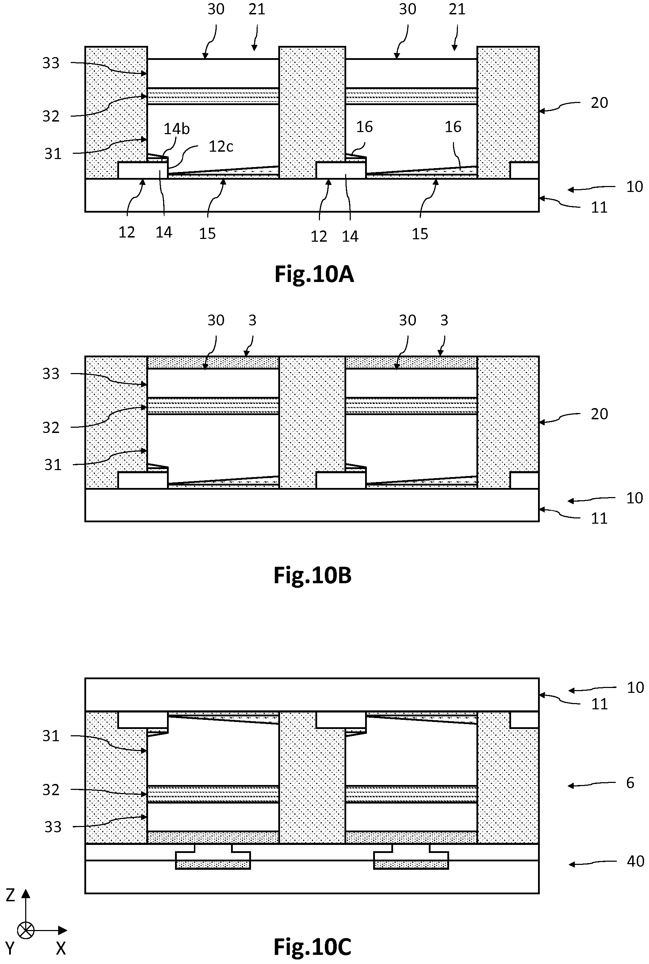

Les figures 10A à 10E illustrent un procédé de fabrication d'un dispositif optoélectronique 1 selon une variante de celui décrit précédemment en référence aux fig.2A-2G.

Dans cet exemple, la surface de nucléation 12b est similaire ou identique à celle décrite en référence aux fig.9A-9B. Il apparaît que dans ce mode de réalisation, comme dans celui des fig.7A-7B, où le composé semiconducteur est épitaxié à partir d'une face latérale 12c de nucléation et où la surface de fond est formée par une région diélectrique 13 (zone oxydée ou nitrurée, ou couche mince diélectrique 15), un espace vide 16 peut être formé entre le composé semiconducteur épitaxié et la face supérieure de la région diélectrique 13. Dans l'exemple de la fig.10A, cet espace vide 16 est situé au-dessus de la couche mince diélectrique 15, tant au niveau de la partie au contact du substrat support 11, que de celle au contact de la partie en saillie 14. Cet espace vide 16 peut être formé lors de la croissance épitaxiale du composé semiconducteur selon des plans cristallins privilégiés, étant donné qu'il croît à partir de la face latérale 12c suivant une direction de croissance principale orientée suivant l'axe Z.

En référence à la fig.10A, on réalise les empilements semiconducteurs 30 dans les ouvertures traversantes 21, à partir des faces latérales de nucléation 12c. A titre d'exemple, la partie en saillie peut présenter une épaisseur de 300nm environ et être en saillie sur une distance de 200nm environ. La couche mince diélectrique 15 peut présenter une épaisseur de 10-20nm. Ainsi, la face latérale de nucléation 12c présente une hauteur suivant l'axe Z de 280nm environ. L'épaisseur de la portion dopée 31 peut être de quelques microns. La portion dopée 31 peut être un composé semiconducteur à base de GaN, dont au moins la partie au contact de la zone active 32 est dopée n.

En référence à la fig.10B, on réalise ensuite les électrodes de polarisation 3, de manière identique ou similaire aux étapes décrites précédemment en référence aux fig.2E et 2F, voire à la fig.3C.

En référence à la fig.10C, on réalise une hybridation de la structure optoélectronique 6 avec une puce de commande 40. Celle-ci est similaire ou identique à celle décrite en référence à la fig.2G, mais elle peut être identique ou similaire à celle de la fig.3D.

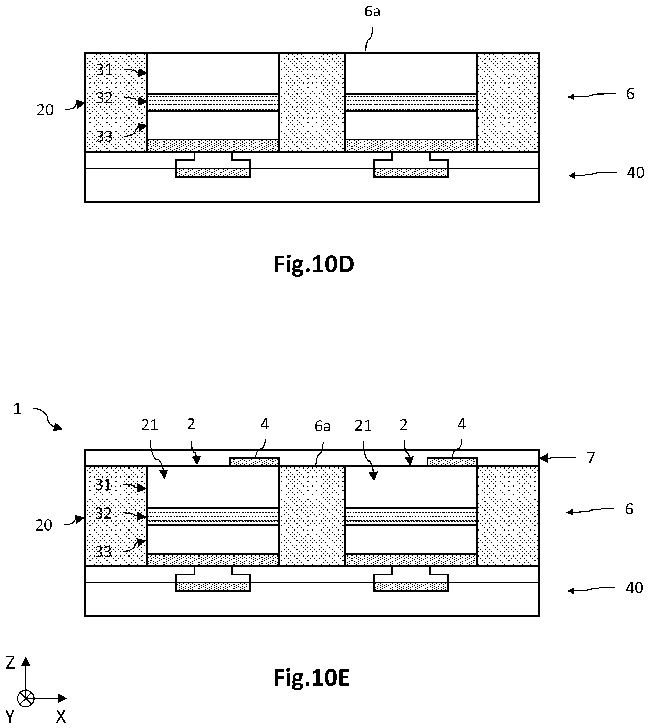

En référence à la fig.10D, on retire ensuite le substrat de croissance 10, mais également une partie des portions dopées 31, par exemple par planarisation mécano-chimique, par gravure sèche, par laser LLO, par abrasion, en autre. La partie supprimée des portions dopées 31 comporte le ou les espaces vides 16. On obtient ainsi une face inférieure 6a de la structure optoélectronique 6 qui est continue et sensiblement plane. Par ailleurs, les portions dopées 31 restantes sont exemptes d'espaces vides issus de la nucléation du composé semiconducteur.

En référence à la fig.10E, on réalise ensuite des premières électrodes 4 de polarisation en contact électrique avec les premières portions 31 dopées n. Une couche de protection 7, réalisée en un matériau diélectrique et transparent au rayonnement électromagnétique, peut ensuite être déposée sur la face d'émission 6a de la structure optoélectronique 6, de manière à assurer une protection structurelle des diodes 2.

On obtient ainsi un dispositif optoélectronique 1, dont la structure optoélectronique 6 comporte une matrice de diodes 2 localisées dans les ouvertures traversantes 21 du masque de croissance 20 et isolées les unes des autres par ce dernier. Comme décrit précédemment, le dispositif optoélectronique 1 présente une bonne qualité cristalline du matériau des portions dopées 31 et de la zone active 32, dans la mesure où on a évité les risques de coalescence du composé semiconducteur épitaxié susceptible de former des défauts structuraux pouvant s'étendre jusqu'à la zone active.

Des modes de réalisation particuliers viennent d'être décrits. Ils ne sont pas exclusifs les uns des autres et peuvent être combinés entre eux, de sorte que différentes variantes et modifications apparaîtront à l'homme du métier. Ainsi, dans les différentes variantes, les ouvertures traversantes 21 peuvent être inclinées suivant un axe directeur formant un angle β non nul par rapport à l'axe Z et/ou structurées de manière à comporter plusieurs cavités distinctes les unes des autres. L'objet de la protection conférée est défini par les revendications qui suivent.

## Revendications

1. Procédé de fabrication d'un dispositif optoélectronique (1) à matrice de diodes (2), chaque diode (2) comportant : un empilement semiconducteur (30) formé d'une première portion dopée (31) et d'une deuxième portion dopée (33) entre lesquelles est située une zone active (32) et présentant un coefficient de dilatation thermique αₑₛ, le procédé comportant les étapes suivantes :
i) fournir un substrat de croissance (10) présentant un coefficient de dilatation thermique α_{sc} inférieur à αₑₛ, comportant un substrat support (11) revêtu d'une couche de nucléation (12) définissant une surface de nucléation (12b);
ii) déposer, sur la surface de nucléation (12b), une couche diélectrique (20) réalisée en un matériau électriquement isolant présentant un coefficient de dilatation thermique α_{mc} inférieur à αₑₛ ;
iii) former, dans la couche diélectrique (20), une pluralité d'ouvertures traversantes (21), débouchant sur la surface de nucléation (12b),
∘ graver la couche de nucléation (12) située dans les ouvertures traversantes (21) de manière à rendre libre une surface supérieure du substrat support (11), et à exposer une face latérale de la couche de nucléation (12) formant une face latérale de nucléation (12c), puis
∘ former une région diélectrique (13, 15) s'étendant dans ou sur le substrat support, de sorte que, lors de l'étape iv) de croissance épitaxiale, chaque première portion dopée (31) est formée notamment à partir de la face latérale de nucléation (12c) ;
iv) réaliser par croissance épitaxiale, dans les ouvertures traversantes (21) et à partir de la surface de nucléation (12b), lesdits empilements semiconducteurs (30), de sorte qu'au moins les premières portions dopées (31) et les zones actives (32) sont situées dans les ouvertures traversantes (21).

2. Procédé de fabrication selon la revendication 1, dans lequel chaque ouverture traversante (21) comporte une seule surface de nucléation (12b), laquelle s'étend sur une partie du contour de l'ouverture traversante (21), et dont la face latérale de nucléation (12c) s'étend, dans un plan parallèle au plan du substrat support (11), de manière convexe ou continûment rectiligne.

3. Procédé de fabrication selon la revendication 2, chaque ouverture traversante étant délimitée transversalement par au moins une bordure latérale (22) de la couche diélectrique (20), dans lequel la face latérale de nucléation (12c) affleure la bordure latérale (22).

4. Procédé de fabrication selon la revendication 2, dans lequel chaque ouverture traversante (21) comporte une partie en saillie (14) de la couche de nucléation, la partie en saillie (14) s'étendant dans l'ouverture traversante (21) sur le substrat support (11) et étant non revêtue par la couche diélectrique (20).

5. Procédé de fabrication selon la revendication 4, dans lequel une face supérieure (14b) de la partie en saillie (14) participe à former la surface de nucléation (12b).

6. Procédé de fabrication selon la revendication 4, comportant une étape de dépôt d'une couche mince diélectrique (15) de manière à recouvrir une face supérieure (14b) de la partie en saillie (14) ainsi qu'une face supérieure du substrat support (11) formant ainsi la région diélectrique (13, 15), tout en laissant libre la face latérale de nucléation (12c).

7. Procédé de fabrication selon l'une quelconque des revendications 1 à 6, dans lequel la région diélectrique (13, 15) est formée par oxydation ou nitruration du substrat support (11) à base de silicium, ou par dépôt d'une couche mince diélectrique (15).

8. Procédé de fabrication selon l'une quelconque des revendications 1 à 7, dans lequel, lors de l'étape de croissance épitaxiale, des espaces vides (16) sont formés entre les empilements semiconducteurs (30) et la région diélectrique (13, 15), et dans lequel l'étape iv) de croissance épitaxiale est suivie d'une étape de retrait du substrat de croissance (10) et d'une partie des empilements semiconducteurs (30) contenant lesdits espaces vides (16).

9. Procédé de fabrication selon l'une quelconque des revendications 1 à 8, dans lequel la couche diélectrique (20) présente une épaisseur e_{mc}, et chaque empilement semiconducteur (30) présente une épaisseur eₑₛ inférieure à e_{mc}, et dans lequel l'étape iv) de croissance épitaxiale est suivie d'une étape de réalisation de deuxièmes électrodes (3) reposant sur et en contact électrique avec les deuxièmes portions dopées (33), comportant les sous-étapes suivantes :
- déposer une couche conductrice (5) d'une épaisseur au moins égale à la différence entre e_{mc} et eₑₛ, réalisée en au moins un matériau électriquement conducteur, de manière à recouvrir les empilements semiconducteurs (30) et une face supérieure (20b) de la couche diélectrique (20),
- planariser la couche conductrice (5), avec arrêt sur la face supérieure (20b) de la couche diélectrique (20), formant ainsi une pluralité de deuxièmes électrodes (3) au contact avec les deuxièmes portions dopées (33) et entourées chacune par la couche diélectrique (20), la face supérieure (20b) de la couche diélectrique (20) et une face supérieure (3b) des deuxièmes électrodes (3) formant alors une surface supérieure (6b) continue et sensiblement plane d'une structure optoélectronique (6).

10. Procédé de fabrication selon la revendication 9, l'épaisseur eₑₛ étant inférieure à e_{mc}, dans lequel l'étape iv) est suivie d'une étape de planarisation de la couche diélectrique (20) avec arrêt de gravure sur une face supérieure (30b) des empilements semiconducteurs (30), une face supérieure (20b) de la couche diélectrique (20) et la face supérieure (30b) des empilements semiconducteurs (30) formant alors une surface supérieure (6b) continue et sensiblement plane d'une structure optoélectronique (6).

11. Procédé de fabrication selon la revendication 9 ou 10, comportant une étape d'hybridation de la structure optoélectronique (6), au niveau de sa surface supérieure (6b), avec une puce de commande (40) adaptée à appliquer une différence de potentiel aux diodes (2).

12. Procédé de fabrication selon la revendication 11, dans lequel la structure optoélectronique (6) et la puce de commande (40) sont hybridées par collage direct.

13. Procédé de fabrication selon l'une quelconque des revendications 1 à 12, chaque deuxième portion dopée (33) comportant une première partie (33.1) et une deuxième partie (33.2) surdopée, la première partie (33.1) étant située entre la deuxième partie (33.2) surdopée et la zone active (32), et la deuxième partie (33.2) surdopée présentant un niveau de dopage supérieur à celui de la première partie (33.1) et un type de conductivité de type p.

14. Procédé de fabrication selon l'une quelconque des revendications 1 à 13, dans lequel, à la suite de l'étape iii), chaque ouverture traversante (21) comporte une première cavité (23) débouchant sur la surface de nucléation (12b), et une deuxième cavité (26) débouchant au niveau d'une face supérieure (20b) de la couche diélectrique (20) et communiquant avec la première cavité (23), la couche diélectrique (20) comportant une partie (27) s'étendant sur le substrat de croissance (10) et délimitant partiellement la deuxième cavité (26), la deuxième cavité (26) étant décalée latéralement par rapport à la première cavité (23) de sorte que, à la suite de l'étape iv), la zone active (32) n'est pas située à l'aplomb de la surface de nucléation (12b).

## Patentansprüche

1. Herstellungsverfahren einer optoelektronischen Vorrichtung (1) mit einer Matrix von Dioden (2), wobei jede Diode (2) Folgendes umfasst: einen Halbleiterstapel (30), der aus einem ersten dotierten Abschnitt (31) und einem zweiten dotierten Abschnitt (33), zwischen denen sich ein aktiver Bereich (32) befindet, gebildet ist und einen Wärmeausdehnungskoeffizienten αₑₛ aufweist, wobei das Verfahren die folgenden Schritte umfasst:
i) Bereitstellen eines Wachstumssubstrats (10), das einen Wärmeausdehnungskoeffizienten α_{sc} aufweist, der kleiner als αₑₛ ist, und ein Trägersubstrat (11) umfasst, das mit einer Keimbildungsschicht (12) überzogen ist, die eine Keimbildungsoberfläche (12b) definiert;
ii) Aufbringen, auf die Keimbildungsoberfläche (12b), einer dielektrischen Schicht (20), die aus einem elektrisch isolierenden Material hergestellt ist, das einen Wärmeausdehnungskoeffizienten α_{mc} aufweist, der kleiner als αₑₛ ist;
iii) Bilden, in der dielektrischen Schicht (20), einer Vielzahl von Durchgangsöffnungen (21), die bis zu der Keimbildungsoberfläche (12b) führen,
o Ätzen der Keimbildungsschicht (12), die sich in den Durchgangsöffnungen (21) befindet, um eine obere Oberfläche des Trägersubstrats (11) frei zu machen und eine Seitenfläche der Keimbildungsschicht (12) freizulegen, die eine Keimbildungsseitenfläche (12c) bildet, dann
o Bilden einer dielektrischen Region (13, 15), die sich in oder auf dem Trägersubstrat erstreckt, sodass während des Schritts iv) des epitaktischen Wachstums jeder erste dotierte Abschnitt (31) insbesondere ab der Keimbildungsseitenfläche (12c) gebildet wird;
iv) Herstellen, durch epitaktisches Wachstum, in den Durchgangsöffnungen (21) und ab der Keimbildungsoberfläche (12b), der Halbleiterstapel (30), sodass sich mindestens die ersten dotierten Abschnitte (31) und die aktiven Bereiche (32) in den Durchgangsöffnungen (21) befinden.

2. Herstellungsverfahren nach Anspruch 1, wobei jede Durchgangsöffnung (21) eine einzige Keimbildungsoberfläche (12b) umfasst, die sich auf einem Teil der Kontur der Durchgangsöffnung (21) erstreckt und deren Keimbildungsseitenfläche (12c) sich in einer zu der Ebene des Trägersubstrats (11) parallelen Ebene auf konvexe oder kontinuierlich geradlinige Weise erstreckt.

3. Herstellungsverfahren nach Anspruch 2, wobei jede Durchgangsöffnung in Querrichtung durch mindestens einen Seitenrand (22) der dielektrischen Schicht (20) begrenzt wird, wobei die Keimbildungsseitenfläche (12c) mit dem Seitenrand (22) bündig ist.

4. Herstellungsverfahren nach Anspruch 2, wobei jede Durchgangsöffnung (21) einen vorspringenden Teil (14) der Keimbildungsschicht umfasst, wobei sich der vorspringende Teil (14) in der Durchgangsöffnung (21) auf dem Trägersubstrat (11) erstreckt und nicht von der dielektrischen Schicht (20) überzogen ist.

5. Herstellungsverfahren nach Anspruch 4, wobei eine obere Fläche (14b) des vorspringenden Teils (14) an der Bildung der Keimbildungsoberfläche (12b) mitwirkt.

6. Herstellungsverfahren nach Anspruch 4, umfassend einen Schritt des Aufbringens einer dielektrischen Dünnschicht (15), um eine obere Fläche (14b) des vorspringenden Teils (14) sowie eine obere Fläche des Trägersubstrats (11) abzudecken und so die dielektrische Region (13, 15) zu bilden, wobei die Keimbildungsseitenfläche (12c) frei gelassen wird.

7. Herstellungsverfahren nach einem der Ansprüche 1 bis 6, wobei die dielektrische Region (13, 15) durch Oxidation oder Nitrierung des Trägersubstrats (11) auf Siliziumbasis oder durch Aufbringung einer dielektrischen Dünnschicht (15) gebildet wird.

8. Herstellungsverfahren nach einem der Ansprüche 1 bis 7, wobei während des Schritts des epitaktischen Wachstums Leerräume (16) zwischen den Halbleiterstapeln (30) und der dielektrischen Region (13, 15) gebildet werden und wobei auf den Schritt iv) des epitaktischen Wachstums ein Schritt des Entfernens des Wachstumssubstrats (10) und eines Teils der Halbleiterstapel (30), der die Leerräume (16) enthält, folgt.

9. Herstellungsverfahren nach einem der Ansprüche 1 bis 8, wobei die dielektrische Schicht (20) eine Dicke e_{mc} aufweist und wobei jeder Halbleiterstapel (30) eine Dicke eₑₛ aufweist, die kleiner als e_{mc} ist, und wobei auf den Schritt iv) des epitaktischen Wachstums ein Schritt des Herstellens zweiter Elektroden (3), die auf den zweiten dotierten Abschnitten (33) liegen und mit ihnen in elektrischem Kontakt sind, folgt, der die folgenden Unterschritte umfasst:
- Aufbringen einer leitenden Schicht (5) mit einer Dicke, die mindestens gleich der Differenz zwischen e_{mc} und eₑₛ ist, hergestellt aus mindestens einem elektrisch leitenden Material, um die Halbleiterstapel (30) und eine obere Fläche (20b) der dielektrischen Schicht (20) abzudecken,
- Planarisieren der leitenden Schicht (5) mit einem Stopp an der oberen Fläche (20b) der dielektrischen Schicht (20), sodass eine Vielzahl von zweiten Elektroden (3) gebildet wird, die in Kontakt mit den zweiten dotierten Abschnitten (33) sind und jeweils von der dielektrischen Schicht (20) umgeben sind, wobei die obere Fläche (20b) der dielektrischen Schicht (20) und eine obere Fläche (3b) der zweiten Elektroden (3) auf diese Weise eine durchgehende und im Wesentlichen ebene obere Oberfläche (6b) einer optoelektronischen Struktur (6) bilden.

10. Herstellungsverfahren nach Anspruch 9, wobei die Dicke eₑₛ kleiner als e_{mc} ist, wobei auf den Schritt iv) ein Schritt des Planarisierens der dielektrischen Schicht (20) mit einem Ätzstopp an einer oberen Fläche (30b) der Halbleiterstapel (30) folgt, wobei eine obere Fläche (20b) der dielektrischen Schicht (20) und die obere Fläche (30b) der Halbleiterstapel (30) auf diese Weise eine durchgehende und im Wesentlichen ebene obere Oberfläche (6b) einer optoelektronischen Struktur (6) bilden.

11. Herstellungsverfahren nach Anspruch 9 oder 10, umfassend einen Schritt der Hybridisierung der optoelektronischen Struktur (6), im Bereich ihrer oberen Oberfläche (6b), mit einem Steuerchip (40), der dazu angepasst ist, eine Potenzialdifferenz an die Dioden (2) anzulegen.

12. Herstellungsverfahren nach Anspruch 11, wobei die optoelektronische Struktur (6) und der Steuerchip (40) durch direkte Bindung hybridisiert werden.

13. Herstellungsverfahren nach einem der Ansprüche 1 bis 12, wobei jeder zweite dotierte Abschnitt (33) einen ersten Teil (33.1) und einen zweiten überdotierten Teil (33.2) umfasst, wobei sich der erste Teil (33.1) zwischen dem zweiten überdotierten Teil (33.2) und dem aktiven Bereich (32) befindet und der zweite überdotierte Teil (33.2) einen Dotierungsgrad, der größer als derjenige des ersten Teils (33.1) ist, und einen Leitfähigkeitstyp vom Typ p aufweist.

14. Herstellungsverfahren nach einem der Ansprüche 1 bis 13, wobei im Anschluss an den Schritt iii) jede Durchgangsöffnung (21) einen ersten Hohlraum (23), der zu der Keimbildungsoberfläche (12b) führt, und einen zweiten Hohlraum (26), der bis zu einer oberen Fläche (20b) der dielektrischen Schicht (20) führt und mit dem ersten Hohlraum (23) kommuniziert, umfasst, wobei die dielektrische Schicht (20) einen Teil (27) umfasst, der sich auf dem Wachstumssubstrat (10) erstreckt und den zweiten Hohlraum (26) teilweise abgrenzt, wobei der zweite Hohlraum (26) mit Bezug auf den ersten Hohlraum (23) seitlich versetzt ist, sodass sich im Anschluss an den Schritt iv) der aktive Bereich (32) nicht lotrecht zu der Keimbildungsoberfläche (12b) befindet.

## Claims

1. Process for fabricating an optoelectronic device (1) comprising a matrix-array of diodes (2), each diode (2) comprising: a semiconductor stack (30) formed from a first doped segment (31) and from a second doped segment (33) between which segments is located an active region (32), and having a coefficient of thermal expansion αₑₛ, the process comprising the following steps:
i) providing a growth substrate (10) having a coefficient of thermal expansion α_{sc} lower than αₑₛ and comprising a carrier substrate (11) coated with a nucleation layer (12) defining a nucleation surface (12b);
ii) depositing, on the nucleation surface (12b), a dielectric layer (20) made of an electrically insulating material having a coefficient of thermal expansion α_{mc} lower than aes;
iii) forming, in the dielectric layer (20), a plurality of through-apertures (21) that open onto the nucleation surface (12b),
∘ etching the nucleation layer (12) located in the through-apertures (21) so as to free an upper surface of the carrier substrate (11) and to expose a lateral face of the nucleation layer (12) forming a nucleation lateral face (12c), then
∘ forming a dielectric region (13, 15) extending through or over the carrier substrate, so that, in step iv) of epitaxial growth, each first doped segment (31) is especially formed from the nucleation lateral face (12c);
iv) producing, by epitaxial growth, in the through-apertures (21) and from the nucleation surface (12b), said semiconductor stacks (30), so that at least the first doped segments (31) and the active regions (32) are located in the through-apertures (21).

2. Fabricating process according to Claim 1, wherein each through-aperture (21) comprises a single nucleation surface (12b), which extends over one portion of the outline of the through-aperture (21), and the nucleation lateral face (12c) of which extends, in a plane parallel to the plane of the carrier substrate (11), in a convex or continuously rectilinear manner.

3. Fabricating process according to Claim 2, each through-aperture being bounded transversely by at least one lateral border (22) of the dielectric layer (20), wherein the nucleation lateral face (12c) is flush with the lateral border (22).

4. Fabricating process according to Claim 2, wherein each through-aperture (21) comprises a protruding portion (14) of the nucleation layer, the protruding portion (14) extending into the through-aperture (21) on the carrier substrate (11) and not being coated by the dielectric layer (20).

5. Fabricating process according to Claim 4, wherein an upper face (14b) of the protruding portion (14) participates in forming the nucleation surface (12b).

6. Fabricating process according to Claim 4, comprising a step of depositing a thin dielectric layer (15) so as to cover an upper face (14b) of the protruding portion (14) and an upper face of the carrier substrate (11) thus forming the dielectric region (13, 15), while leaving free the nucleation lateral face (12c).

7. Fabricating process according to any one of Claims 1 to 6, wherein the dielectric region (13, 15) is formed by oxidation or nitridation of the silicon-based carrier substrate (11), or by depositing a thin dielectric layer (15).

8. Fabricating process according to any one of Claims 1 to 7, wherein, in the epitaxial growth step, empty spaces (16) are formed between the semiconductor stacks (30) and the dielectric region (13, 15) , and wherein step iv) of epitaxial growth is followed by a step of removing the growth substrate (10) and a portion of the semiconductor stacks (30) containing said empty spaces (16).

9. Fabricating process according to any one of Claims 1 to 8, wherein the dielectric layer (20) has a thickness e_{mc}, and each semiconductor stack (30) has a thickness eₑₛ smaller than e_{mc}, and wherein step iv) of epitaxial growth is followed by a step of producing second electrodes (3) resting on and in electrical contact with the second doped segments (33), this step comprising the following sub-steps:
- depositing a conductive layer (5) of a thickness at least equal to the difference between e_{mc} and eₑₛ, made of at least one electrically conductive material, so as to cover the semiconductor stacks (30) and an upper face (20b) of the dielectric layer (20),
- planarizing the conductive layer (5), with the upper face (20b) of the dielectric layer (20) employed as etch-stop, so as thus to form a plurality of second electrodes (3) that make contact with the second doped segments (33) and that are each surrounded by the dielectric layer (20), the upper face (20b) of the dielectric layer (20) and an upper face (3b) of the second electrodes (3) then forming a continuous and substantially planar upper surface (6b) of an optoelectronic structure (6).

10. Fabricating process according to Claim 9, the thickness eₑₛ being smaller than e_{mc}, wherein step iv) is followed by a step of planarizing the dielectric layer (20), with an upper face (30b) of the semiconductor stacks (30) employed as etch-stop, an upper face (20b) of the dielectric layer (20) and the upper face (30b) of the semiconductor stacks (30) then forming a continuous and substantially planar upper surface (6b) of an optoelectronic structure (6).

11. Fabricating process according to Claim 9 or 10, comprising a step of hybridizing the optoelectronic structure (6), via its upper surface (6b), with a control chip (40) suitable for applying a potential difference to the diodes (2).

12. Fabricating process according to Claim 11, wherein the optoelectronic structure (6) and the control chip (40) are hybridized by direct bonding.

13. Fabricating process according to any one of Claims 1 to 12, each second doped segment (33) comprising a first portion (33.1) and an overdoped second portion (33.2), the first portion (33.1) being located between the overdoped second portion (33.2) and the active region (32), and the overdoped second portion (33.2) having a doping level higher than that of the first portion (33.1) and a p-type conductivity type.

14. Fabricating process according to any one of Claims 1 to 13, wherein, following step iii), each through-aperture (21) comprises a first cavity (23) that opens onto the nucleation surface (12b), and a second cavity (26) that opens onto an upper face (20b) of the dielectric layer (20) and that communicates with the first cavity (23), the dielectric layer (20) comprising a portion (27) extending over the growth substrate (10) and partially bounding the second cavity (26), the second cavity (26) being laterally offset with respect to the first cavity (23) so that, following step iv), the active region (32) is not located plumb with the nucleation surface (12b).
